(19) Europäisches Patentamt / European Patent Office / Office européen des brevets

(11) **EP 2 495 284 B1**

(12) **EUROPEAN PATENT SPECIFICATION**

(45) Date of publication and mention
of the grant of the patent:
**28.09.2016  Bulletin 2016/39**

(21) Application number: **10826552.1**

(22) Date of filing: **19.10.2010**

(51) Int Cl.:
*C08L 67/02* (2006.01)  *B29C 55/12* (2006.01)
*B32B 27/36* (2006.01)  *C08J 3/22* (2006.01)
*C08J 5/18* (2006.01)  *C08K 3/00* (2006.01)
*C08L 81/02* (2006.01)  *H01L 31/042* (2006.01)

(86) International application number:
**PCT/JP2010/068297**

(87) International publication number:
**WO 2011/052420 (05.05.2011 Gazette 2011/18)**

(54) **BIAXIALLY ORIENTED POLYESTER FILM**

BIAXIAL AUSGERICHTETE POLYESTERFOLIE

FILM POLYESTER BI-ORIENTÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.10.2009  JP 2009247325**

(43) Date of publication of application:
**05.09.2012  Bulletin 2012/36**

(73) Proprietor: **Toray Industries, Inc.
Tokyo 103-8666 (JP)**

(72) Inventors:
• **SHIOMI, Atsushi**
  **Otsu-shi**
  **Shiga 520-8558 (JP)**
• **AOYAMA, Shigeru**
  **Otsu-shi**
  **Shiga 520-8558 (JP)**
• **SHIMAZU, Ayako**
  **Otsu-shi**
  **Shiga 520-8558 (JP)**
• **TAKAHASHI, Kozo**
  **Otsu-shi**
  **Shiga 520-8558 (JP)**

(74) Representative: **Kador & Partner
Corneliusstraße 15
80469 München (DE)**

(56) References cited:
EP-A1- 1 876 008      WO-A1-2010/140611
JP-A- 3 263 434       JP-A- 9 286 905
JP-A- 2005 068 360    JP-A- 2005 096 477
JP-A- 2006 056 518    JP-A- 2006 117 907
JP-A- 2006 161 037    JP-A- 2007 069 914
US-A1- 2005 118 406

**Description**

TECHNICAL FIELD

The present invention relates to a biaxially oriented polyester film which can be suitably used especially as a solar battery back sheet, and also relates to a method of producing the film, and a solar battery back sheet and a solar battery using the film.

BACKGROUND ART

Polyester resins have been used in various uses because they have excellent mechanical properties, thermal properties, chemical resistance, electrical properties, and moldability, and are inexpensive. A biaxially oriented polyester film obtained by making the polyester resin into a film has been used as an electrical insulating material, for example, for copper-clad laminates, solar battery back sheets, adhesive tapes, flexible printed boards, membrane switches, planar heating elements, or flat cables; a magnetic recording material; a capacitor material; a packaging material; an automotive material; a building material; and various industrial materials, for example, for photographic use, graphic use, and thermosensitive transcription use.

Among these uses, an electrical insulating material used, in particular, outdoors (for example, solar battery back sheets and the like), an automotive material, and a building material are often used in harsh environments in terms of temperature and humidity over a long period of time, and general polyester resins can discolor to brown when exposed to UV light for a long period of time. Further, UV irradiation and hydrolysis reduce the molecular weight, promoting embrittlement to reduce the mechanical properties and the like. Therefore, there is a need for inhibition of the change in color tone due to UV light and the reduction in tensile elongation and for improvement of hydrolysis resistance. Accordingly, various studies have been made in order to inhibit the hydrolysis of polyester resins.

For example, the technique for improving the hydrolysis resistance of a polyester resin itself by adding a polyester resin which contains a certain amount of alkali metal, alkaline earth metal, and phosphorus and contains internally precipitated particles due to catalyst residues (Patent Document 1), an epoxy compound (Patent Document 2, Patent Document 3), or polycarbodiimide (Patent Document 4) had been studied. For the biaxially oriented polyester film, the improvement of hydrolysis resistance by providing a film with high IV (high intrinsic viscosity) and controlling the planar orientation had been studied (Patent Document 5).

On the other hand, for application in these uses, high functionalization by providing the properties other than hydrolysis resistance (in particular, UV light resistance, reflectivity, and the like) as well has been desired. Therefore, higher functionalization by mixing a bi- or multi-component polyester or other components has been studied (for example, Patent Documents 6, 7, 8, and 9).

US2005/0118406 discloses a biaxially-oriented film for bottles, packaging and labels, comprising: a matrix of a first polymer such as PET; and a dispersed phase of another polymer such as polycyclohexylene terephthalate, the particle size of the dispersed phase being less than 10 $\mu$m. The co-presence of inorganic particles is optional.

PRIOR ART DOCUMENTS

PATENT DOCUMENTS

Patent Document 1: JP 60-31526 A
Patent Document 2: JP 09-227767 A
Patent Document 3: JP 2007-302878 A
Patent Document 4: JP 11-506487 W
Patent Document 5: JP 2007-70430 A
Patent Document 6: JP 2004-223714 A
Patent Document 7: JP 2004-98442 A
Patent Document 8: JP 02-191638 A
Patent Document 9: JP 08-244188 A

## SUMMARY OF THE INVENTION

### PROBLEMS TO BE SOLVED BY THE INVENTION

However, in the case where other components (for example, UV absorbers, inorganic particles, and the like) are mixed for high functionalization of a polyester film, the process comprising the steps of kneading the other components with a resin once for masterpelletization and diluting the masterpellet with a polyester resin constituting the film is generally carried out. However, in general, when producing a masterpellet, thermal histories during extrusion process deteriorates a polyester resin. By adding the master chips thus produced, a deteriorated resin is contained in the film, and therefore there is a problem in that the film obtained has a reduced hydrolysis resistance though it expresses the functions of the components added (in particular, UV light resistance). Further, in cases where inorganic particles are contained for high functionalization, there is a problem in that, for example, the hydrolysis resistance of the film is reduced by the influence, for example, of the water adsorbed in the inorganic particles.

Thus, an object of the present invention is to provide a biaxially oriented polyester film which has excellent hydrolysis resistance and can simultaneously achieve other properties (in particular, inhibition of the change in color tone and inhibition of the reduction in tensile elongation after UV irradiation).

### MEANS FOR SOLVING THE PROBLEMS

To solve the above-described problems, the biaxially oriented polyester film of the present invention has constitution below:

A biaxially oriented polyester film which is a polyester film having a polyester layer (P1 layer) containing a polyester (A1) comprising ethylene terephthalate as a main constituent, a high melting point resin (B1) having a melting point $Tm_{B1}$ of not less than 260°C and not more than 320°C, and inorganic particles (C1), wherein the content of the high melting point resin (B1) in the P1 layer, $W_{B1}$, is not less than 2% by mass and not more than 40% by mass based on the P1 layer; in the P1 layer, a dispersion phase(s) composed of the high melting point resin (B1) is/are present in the polyester (A1); and the average longitudinal length of the dispersion phase is not more than 10,000 nm (10 $\mu$m).

The solar battery back sheet of the present invention has the following constitution:

A solar battery back sheet using the biaxially oriented polyester filmdescribed above.

The solar battery of the present invention has the following constitution:

A solar battery using the solar battery back sheet described above.

The method of producing the biaxially oriented polyester film of the present invention has constitution below:

A method of producing the biaxially oriented polyester film according described above, which is a method of producing the polyester film having the polyester layer (P1 layer) containing the polyester (A1) comprising ethylene terephthalate as a main component; at least one high melting point resin (B1) selected from the group consisting of resins comprising 1,4-cyclohexanedimethylene terephthalate, ethylene-2,6-naphthalenedicarboxylate, and phenylene sulfide as a main component; and the inorganic particles (C1), wherein the high melting point resin (B1) and the inorganic particles (C1) are melt kneaded to produce a masterpellet (M1); and the polyester (A1) and the masterpellet (M1) are melt kneaded under conditions satisfying any of the following equations (i) to (iv), extruded into sheet form, and then biaxially stretched;

wherein the melt viscosity of the polyester (A1) is $\eta_A$; the melt viscosity of the masterpellet (M1) is $\eta_{M1}$; $Tm_{B1}$ is the melting point (°C) of the high melting point resin (B1); Tc is the extrusion temperature (°C) during melt film forming; and $\eta_A$ and $\eta_{M1}$ are the melt viscosity of the polyester (A1) and the masterpellet (M1), respectively, at a temperature of Tc (°C) and a shear rate of 200 sec$^{-1}$;

$$\eta_A/\eta_{M1} \geq 0.2 \quad (i)$$

$$\eta_A/\eta_{M1} \leq 1.0 \quad (ii)$$

$$\eta_A/\eta_{M1} \geq -0.16 \times (Tc - Tm_{B1}) + 2.6 \quad (iii)$$

$$\eta_A/\eta_{M1} \leq -0.08 \times (Tc - Tm_{B1}) + 2.6 \quad (iv).$$

In the biaxially oriented polyester film according to the present invention, it is preferred that, in the above-described P1 layer, 70% or more of the total number of the above-described inorganic particles (C1) be present in the above-described dispersion phases or in contact with the above-described dispersion phases.

In the biaxially oriented polyester film according to the present invention, the above-described high melting point resin (B1) is preferably at least one resin selected from the group consisting of resins comprising 1,4-cyclohexanedimethylene terephthalate, ethylene-2,6-naphthalenedicarboxylate, and phenylene sulfide as a main component.

The biaxially oriented polyester film according to the present invention is a laminated polyester film having the above-described polyester layer (P1) layer and a polyester layer (P2 layer) containing a polyester (A2) comprising ethylene terephthalate as a main constituent, a high melting point resin (B2) having a melting point of not less than 260°C and not more than 320°C, and inorganic particles (C2), and it is preferred that, in the P2 layer, dispersion phases composed of the high melting point resin (B2) be present in the polyester (A2); the content of the inorganic particles (C2) in the P2 layer, $W_{C2}$, be not less than 0.1% by mass and not more than 5% by mass based on the P2 layer; and the difference between the content of the inorganic particles (C1) in the P1 layer, $W_{C1}$ (% by mass), and the content of the inorganic particles (C2) in the P2 layer, $W_{C2}$ (% by mass), $W_{C1} - W_{C2}$, be not less than 5% by mass and not more than 25% by mass.

In the solar battery back sheet of the present invention, it is preferable to provide the above-described polyester film at at least one outermost side.

In the solar battery back sheet of the present invention, at least one outermost layer is preferably the P1 layer.

EFFECTS OF THE INVENTION

The present invention provides a biaxially oriented polyester film comprising ethylene terephthalate as a main component which allows a balance between high hydrolysis resistance and other properties (in particular, UV light resistance) over a long period of time. Further, the use of such a biaxially oriented polyester film provides a solar battery back sheet with high durability and a solar battery using the same.

BRIEF DESCRIPTION OF THE DRAWINGS

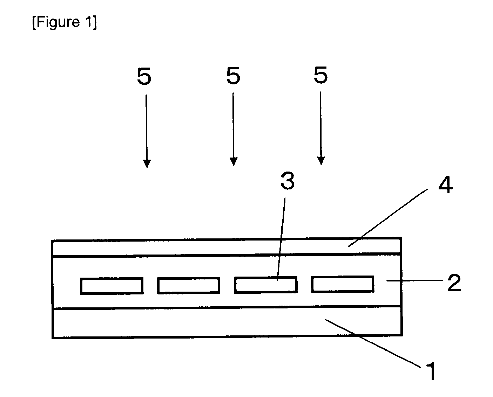

Figure 1 is a schematic cross-sectional view of the solar battery using the film of the present invention.

BEST MODE FOR CARRYING OUT THE INVENTION

The present invention will now be described in detail by way of specific examples.

The biaxially oriented polyester film of the present invention is a biaxially oriented polyester film having a polyester layer (P1 layer) containing a polyester (A1) comprising ethylene terephthalate as a main constituent, a high melting point resin (B1), and inorganic particles (C1).

In the present invention, the polyester (A1) comprising ethylene terephthalate as a main constituent refers to a polyester resin containing ethylene terephthalate units or in an amount of 50 mol% or more. The molar fraction of the ethylene terephthalate units in the polyester (A1) is preferably 80 mol% or more, especially preferably 100 mol% (i.e., the polyester (A1) is polyethylene terephthalate

Generally, polyester is composed of an acid component such as aromatic dicarboxylic acids, aliphatic cyclic dicarboxylic acids, or aliphatic dicarboxylic acids, and a diol component, but in the present invention, a resin obtained by appropriately copolymerizing ethylene terephthalate with other acid component or diol component can also be used as a polyester (A1) as long as the effects of the invention are not impaired.

In the resin comprising polyester as a main component, the presence of ester bonds is the main cause of hydrolysis. Therefore, by forming dispersion phases in the polyester (A1) using a pellet mastered with inorganic particles and a resin containing no ester bonds, more excellent hydrolysis resistance can be provided while obtaining UV light resistance that is the effect of the addition of inorganic particles, which is preferred. Examples of resins containing no ester bonds in the molecular structure include, for example, polyetherimide, polyphenylene sulfide, olefin, nylon, polystyrene, polyphenylene oxide, and polyether ether ketone.

In the biaxially oriented polyester film of the present invention, the intrinsic viscosity (IV) of the polyester (A1) is preferably not less than 0.65, more preferably not less than 0.68, still more preferably not less than 0.7, and especially preferably not less than 0.72. When the IV of the polyester (A1) is not less than 0.65, high hydrolysis resistance and high mechanical properties can be obtained. Although the upper limit of the IV is not particularly defined, from the standpoint of preventing a cost disadvantage due to a too prolonged polymerization time and facilitating the melt extrusion, it is preferably not more than 1.0, and more preferably not more than 0.9.

The polyester (A1) is a polyester resin comprising polyethylene terephthalate as a main component, if the intrinsic viscosity (IV) is 0.65 to 0.9, the melt viscosity $\eta_A$ is from 2,000 poise to 5,000 poise. Here, melt viscosity $\eta_A$ is measured by the Method for evaluating the properties (2) described below.

The biaxially oriented polyester film of the present invention contains inorganic particles (C1). The inorganic particles (C1) are used for providing the film with a function required depending on the purpose. Examples of inorganic particles (C1) which can be suitably used in the present invention include, for example, inorganic particles having UV absorptivity, particles having a large refractive index difference from the polyester (A1), particles having conductivity, and pigments. These improve, for example, UV light resistance, optical properties, antistatic properties, and the color tone.

In the present invention, as inorganic particles, those with an average primary particle diameter of 5 nm or more are used. Particle diameter herein refers to a number average particle diameter and means the particle diameter observed in a cross section of the film. In cases where the shape is not a perfect circle, the value equivalent to that of a perfect circle of the same area is considered as a particle diameter. Number average particle diameter can be determined by the following procedure (1) to (4).

(1) First, using a microtome, a film is cut in the thickness direction without crushing the cross section, and a scanning electron microscope is used to obtain a magnified observation image. At this time, cutting is carried out in the direction parallel to the film TD direction (transverse direction).

(2) Next, for each particle observed in the cross section in the image, its cross-sectional area S is determined, and its particle diameter d is determined using the following equation.

$$d = 2 \times (S / \pi)^{1/2}$$

(3) Using the particle diameter d obtained and the number of resin particles n, Dn is determined by the following equation.

$$Dn = \Sigma d / n$$

wherein, $\Sigma d$ is the summation of particle diameters of the particles in an observation plane; and n is the total number of the particles in the observation plane.

(4) The above (1) to (3) are performed at five different points, and the mean value is defined as the number average particle diameter of the particles. The above-described evaluation is performed at an area of $2.5 \times 10^9$ nm$^2$ (2,500 $\mu$m$^2$) or more for each observation point.

From the standpoint of making it easy to absorb the light in the UV range from 10 nm to 400 nm, the average primary particle diameter of the inorganic particles is preferably not less than 5 nm (0.005 $\mu$m) and not more than 5,000 nm (5 $\mu$m), more preferably not less than 10 nm (0.01 $\mu$m) and not more than 3,000 nm (3 $\mu$m), and especially preferably not less than 15 nm (0.015 $\mu$m) and not more than 2,000 nm (2 $\mu$m).

Specific examples of inorganic particles include, for example, metals such as gold, silver, copper, platinum, palladium, rhenium, vanadium, osmium, cobalt, iron, zinc, ruthenium, praseodymium, chromium, nickel, aluminum, tin, zinc, titanium, tantalum, zirconium, antimony, indium, yttrium, and lanthanum; metal oxides such as zinc oxide, titanium oxide, cesium oxide, antimony oxide, tin oxide, indium tin oxide, yttrium oxide, lanthanum oxide, zirconium oxide, aluminum oxide, and silicon oxide; metal fluorides such as lithium fluoride, magnesium fluoride, aluminum fluoride, and cryolite; metal phosphates such as calcium phosphate; carbonates such as calcium carbonate; sulfates such as barium sulfate; and besides carbonaceous materials such as talc, kaolin, carbon, fullerene, carbon fiber, and carbon nanotube.

In view of the fact that solar batteries are often used outdoors, when inorganic particles having UV absorptivity, for example, metal oxides such as titanium oxide, zinc oxide, and cerium oxide are used, the effect of the of invention, that is, maintaining mechanical strength over a long period of time can be prominently exerted by utilizing the UV light resistance resulting from the inorganic particles.

The content of the inorganic particles contained in the P1 layer of the biaxially oriented polyester film of the present invention is, based on the P1 layer, preferably not less than 0.5% by mass and not more than 30% by mass, more preferably not less than 1.0% by mass and not more than 28% by mass, and still more preferably not less than 3.0% by mass and not more than 25% by mass. The content of the inorganic particles of not less than 0.5% by mass and not more than 30% by mass provides sufficient UV light resistance, mechanical strength that is not reduced when used for a long period of time, and little change in color tone after UV irradiation. In addition, reduced mechanical strength of the film due to too much content of the particles will not be caused.

Weight-average molecular weight in the present invention is measured by the Method for evaluating the properties (11) described below.

Generally, when adding inorganic particles to polyester, to disperse the inorganic particles homogeneously, they are once masterpelletized with another resin, and the masterpellet is dispersed in the polyester. When inorganic particles are added, it is inevitable that the hydrolysis of polyester will be promoted, for example, by the water inherently contained the inorganic particles. Therefore, when a resin having the same composition as that of the polyester resin (A1) is used as a resin for masterpelletization, the hydrolysis resistance of the masterpelletized polyester (A1) will necessarily be worse than the hydrolysis resistance intrinsic to the polyester (A1) because inorganic particles are contained.

Thus, in the present invention, to prevent the reduction of hydrolysis resistance due to inorganic particles, a thermoplastic resin which has a lower rate of weight-average molecular weight decrease when comparing before and after treatment at 125°C and 100% RH for 72 hr than that of the polyester (A1) is used as a resin for masterpelletization.

In the present invention, the polyester (A1) comprises polyethylene terephthalate as a main component, the combination with the high melting point resin (B1) that is at least one resin selected from the group consisting of resins comprising 1,4-cyclohexylenedimethylene terephthalate, ethylene-2,6-naphthalenedicarboxylate, and phenylene sulfide as a main component is preferred. Among the high melting point resins (B1) used in the present invention, polycyclohexylenedimethylene terephthalate preferably has cyclohexylenedimethylene terephthalate units composed of terephthalic acid as a dicarboxylic acid component and cyclohexylenedimethanol as a diol component in an amount of 85 mol% or more, more preferably 90 mol% or more, and especially preferably 93 mol% or more, based on the total repeating units of the high melting point resin (B1), and the upper limit value thereof is 100 mol%. When the cyclohexylenedimethylene terephthalate units contained in the high melting point resin (B1) is 85 mol% or more, crystallinity will not be impaired, and there is no danger of causing a decrease in the melting point. As a result, a polyester film having high heat-resistance, no possibility to cause a reduction in intrinsic viscosity (hereinafter referred to as IV reduction) during the production of a masterpellet, and excellent hydrolysis resistance can be obtained.

In the present invention, the content of the high melting point resin (B1), $W_{B1}$, in the P1 layer needs to be not less than 2% by mass and not more than 40% by mass based on the P1 layer. When the content of the high melting point resin (B1), $W_{B1}$, is less than 2% by mass, the concentration of inorganic particles in a masterpellet becomes high during the production of the masterpellet having inorganic particles. Therefore, sufficient dispersion of inorganic particles cannot be obtained, and it can be impossible to allow 70% or more of the total number of the above-described inorganic particles (C1) to be present in the dispersion phase or to be present in contact with the dispersion phase (hereinafter also referred to as "allow to be present or the like in the dispersion phase"). If the concentration of inorganic particles in a masterpellet is lowered in order to prevent this, the content of inorganic particles in a polyester film is likely to be insufficient, and the effects of the present invention sometimes cannot be obtained. On the other hand, when the content of the high melting point resin (B1), $W_{B1}$, in the P1 layer is more than 40% by mass, the dispersion phases become excessive, which significantly deteriorates film forming ability, and therefore the film sometimes cannot be obtained. When the content of the high melting point resin (B1), $W_{B1}$, is not less than 2% by mass and not more than 40% by mass, hydrolysis resistance, the effect by the addition of the particles, and film forming stability can be achieved simultaneously.

From the standpoint that the high melting point resin (B1) in the present invention prevents IV reduction associated with the extrusion process during masterpelletization with inorganic particles, the melting point of the high melting point resin (B1), $Tm_{B1}$, is preferably 5°C to 60°C higher than the melting point of the polyester (A1), $Tm_{A1}$. When the melting point of the high melting point resin (B1), $Tm_{B1}$, is higher in the range as described above than the melting point of the polyester (A1), $Tm_{A1}$, thermal degradation during the extrusion process in masterpelletization can be prevented.

In the present invention, polyethylene terephthalate is most preferred as the polyester (A1) because it is not only inexpensive but also has excellent mechanical properties. The melting points of these resins, though some degree of error is included depending on the process, are 255°C for polyethylene terephthalate. Therefore, in the present invention, the melting point of the high melting point resin (B1), $Tm_{B1}$, is preferably in the range of not less than 260°C and not more than 320°C. When the melting point of the high melting point resin (B1), $Tm_{B1}$, is in the range of not less than 260°C and not more than 320°C, heat resistance is sufficient, and thermal degradation occurring during the extrusion process in masterpelletization is small; at the same time, there is no need to unduly increase the extrusion temperature during film forming.

The longitudinal length of the dispersion phases is measured by the Method for evaluating the properties (12) described below.

In the biaxially oriented polyester film according to the present invention, the average longitudinal length of the dispersion phases composed of the high melting point resin (B1) is not more than 10,000 nm (10 $\mu$m). If the average longitudinal length of the dispersion phases is more than 10,000 nm (10 $\mu$m), the dispersion phases in the polyester (A1) are large, and the inorganic particles will be in an inhomogeneously dispersed state in the polyester (A1) as mentioned above. As a result, UV light resistance provided by the inorganic particles can be poor. Therefore, when the average longitudinal length of the dispersion phase composed of the high melting point resin (B1) is not more than 10,000 nm (10 $\mu$m), the inorganic particles can be dispersed in the polyester (A1) more homogeneously. Preferred is not more than 6,000 nm (6 $\mu$m). Although the lower limit is not restricted, from the standpoint of reducing the number of interfaces between the inorganic particles and the polyester (A1), the average longitudinal length of the dispersion phases composed of the high melting point resin (B1) is preferably not less than 500 nm (0.5 $\mu$m).

In the biaxially oriented polyester film according to the constitution [1] of the present invention, a preferred means for achieving not more than 10,000 nm (10 $\mu$m) of an average longitudinal length of the dispersion phases composed of the high melting point resin (B1) is as follows:

(1) The inorganic particles (C1) and the high melting point resin (B1) are melt kneaded in advance to obtain a masterpellet (M1).
(2) Using the masterpellet (M1) obtained in (1) and the polyester (A1), these are melt-extruded to obtain a non-oriented sheet. The ratio of the melt viscosity of the polyester (A1), $\eta_A$ (poise), to the melt viscosity of the masterpellet (M1), $\eta_{M1}$ (poise), $\eta_A/\eta_{M1}$, is preferably not more than 1.0 (provided that the melt temperature is the extrusion temperature during melt film forming, Tc (°C)). Although the lower limit of $\eta_A/\eta_{M1}$ is not restricted, $\eta_A/\eta_{M1}$ is preferably not less than 0.2. When $\eta_A/\eta_{M1}$ is not less than 0.2, there is no need to increase the shear rate in order to obtain dispersion phases of not more than 10000 nm (10 $\mu$m), and there is also no danger of the IV reduction due to shear heating. The melt viscosity of the masterpellet can be controlled, for example, by adjusting the molecular weight of the high melting point resin (B1). The average longitudinal length of the dispersion phases composed of the high melting point resin (B1) is the measured by the Method for evaluating the properties (13) described below.
The extrusion temperature during melt film forming, Tc (°C), is preferably set at higher than the melting point of the high melting point resin (B1), $Tm_{B1}$; $Tm_{B1}$ + 10°C and $Tm_{B1}$ + 30°C or lower, and more preferably set at $Tm_{B1}$ + 15°C or higher and $Tm_{B1}$ + 20°C or lower. When Tc (°C) is in the preferred range described above, there is no need to increase the shear rate more than necessary when the resin is extruded, and therefore the IV reduction during melt film forming can be decreased.
Further, considering both $\eta_A/\eta_{M1}$ and the extrusion temperature during melt film forming, Tc (°C), any of (i) to (vi) below is preferably satisfied when the high melting point resin (B1) is used (preferably, at least one is satisfied, more preferably, all of them are satisfied).

$$\eta_A/\eta_{M1} \geq 0.2 \quad (i)$$

$$\eta_A/\eta_{M1} \leq 1.0 \quad (ii)$$

$$\eta_A/\eta_{M1} \geq -0.16 \times (Tc - Tm_{B1}) + 2.6 \quad (iii)$$

$$\eta_A/\eta_{M1} \leq -0.08 \times (Tc - Tm_{B1}) + 2.6 \quad (iv)$$

(3) The non-oriented sheet obtained in (2) is biaxially stretched by known means to obtain the film of the present invention.

In the biaxially oriented polyester film of the present invention, it is preferred that, in the above-described P1 layer, 70% or more of the total number of the above-described inorganic particles (C1) be present in the above-described dispersion phases composed of the high melting point resin (B1) or in contact with the above-described dispersion phases. The upper limit is not particularly limited, and the larger the percentage of the inorganic particles (C1) present in the above-described dispersion phases or in contact with the above-described dispersion phases, the more preferred it is for hydrolysis resistance. However, when 95% or more, the inorganic particles are too locally present, and the UV light resistance effect by the addition of the inorganic particles can be poor. The percentage of the inorganic particles (C1) present in the above-described dispersion phase or in contact with the above-described dispersion phases is preferably not less than 80% and not more than 95%. In the polyester (A1), when the dispersion phases composed of the high melting point resin (B1) allows most of the inorganic particles (C1), preferably 70% or more of the total number, to be present or the like in the above-described dispersion phases, the number of the inorganic particles (C1) in contact with the polyester (A1) can be reduced, which in turn allows effective inhibition of hydrolysis. That is, the presence or the like of the inorganic particles in the above-described dispersion phases not only prevents the promotion of hydrolysis by the inorganic particles, particularly, highly active particles such as titanium oxide, present in the polyester (A1) but also reduces the interfaces between the polyester (A1) and the inorganic particles (C1) to prevent local hydrolysis. This allows a balance between hydrolysis resistance and UV light resistance by the addition of the inorganic particles. Whether the inorganic particles (C1) are present in the above-described dispersion phases or in contact with the dispersion phases in the P1 layer of the biaxially oriented polyester film of the present invention is determined by the Method for evaluating the properties (4) described below.

Examples of specific means for allowing 70% or more of the total number of the inorganic particles (C1) to be present or the like in the dispersion phases composed of the high melting point resin (B1) include, for example, a means in which the inorganic particles (C1) and the high melting point resin (B1) is melt kneaded in advance to form a masterpellet (M1); and melt film forming is performed using the masterpellet (M1) and a pellet of the polyester (A1) as materials. The method of producing the masterpellet (M1) will be described in more detail. It is preferable to dry, if necessary, the high melting point resin (B1) used in kneading; introduce it and the inorganic particles (C1) into an extruder for heating to melt/kneading; and then cut a strand discharged from a die into pieces to form a pelletized masterpellet. Although the screw of the extruder when kneading may be single, a double screw is preferably used for enhancing kneadability. By using the kneading method, the abundance of the inorganic particles in the dispersion phases and the number of the inorganic particles in contact with the dispersion phases can be efficiently increased.

In the biaxially oriented polyester film of the present invention, for allowing the inorganic particles (C1) to be present in the dispersion phases efficiently, it is also a preferred embodiment to select the polyester (A1) and the high melting point resin (B1) such that the ratio of the melt viscosity of the polyester (A1), $\eta_A$, to the melt viscosity of the masterpellet (M1) obtained by kneading the high melting point resin (B1) and the inorganic particles (C1), $\eta_{M1}$, $\eta_A/\eta_{M1}$, is not more than 1.0. When, without using a masterpellet obtained by kneading in advance the inorganic particles (C1) and the high melting point resin (B1), just a mixture composed of a pellet of the polyester (A1), a pellet of the high melting point resin (B1), and the inorganic particles (C1) is introduced into a film forming extruder for melt film forming, it is difficult to allow 70% or more of the total number of the inorganic particles (C1) to be present or the like in the dispersion phases composed of the high melting point resin (B1).

In the biaxially oriented polyester film of the present invention, the content of the inorganic particles in the masterpellet formed by using the inorganic particles and the high melting point resin (B1) is preferably not less than 10% by mass and not more than 70% by mass, more preferably not less than 20% by mass and not more than 60% by mass, and most preferably not less than 40% by mass and not more than 60% by mass. When the particle concentration in the masterpellet is not less than 10% by mass and not more than 70% by mass, it is easy to allow 70% or more of the total number of the inorganic particles (C1) to be present or the like in the dispersion phases composed of the high melting point resin (B1).

In the case where the biaxially oriented polyester film of the present invention is a laminated polyester film having the above-described polyester layer (P1) layer and a polyester layer (P2 layer) containing a polyester (A2) comprising ethylene terephthalate as a main constituent, a high melting point resin (B2), and inorganic particles (C2), also in the P2 layer, dispersion phases composed of the high melting point resin (B2) are preferably present in the polyester (A2). Also in the P2 layer, it is preferable to reduce the number of interfaces between the inorganic particles and the polyester (A2) from the standpoint of maintaining hydrolysis resistance. Thus, it is preferred that the high melting point resin (B2), as in the P1 layer, also be masterpelletized in advance with the inorganic particles and present in the polyester (A2) as dispersion phases.

From the standpoint of decreasing the reduction of hydrolysis resistance due to the inorganic particles, the content of the inorganic particles (C2) in the P2 layer, $W_{C2}$, is preferably not less than 0.1% by mass and not more than 5% by mass based on the P2 layer. In addition, the difference between the content of the inorganic particles (C1) in the P1 layer, $W_{C1}$ (% by mass), and the content of the inorganic particles (C2) in the P2 layer, $W_{C2}$ (% by mass), $W_{C1} - W_{C2}$, is preferably not less than 5% by mass and not more than 25% by mass. This is for providing the constitution in the P2 layer focusing on improving hydrolysis resistance by decreasing the amount of the inorganic particles added to less than that of the P1 layer in contrast to the constitution in the P1 layer focusing on improving UV light resistance by increasing the additional concentration of the inorganic particles to thereby provide the constitution by which the balance of hydrolysis resistance and UV light resistance can be significantly achieved because each two functions are assigned to the two layers.

The lamination ratio of the P1 layer to the P2 layer is preferably 1:3 to 1:8 also from the standpoint of simultaneously achieving hydrolysis resistance and UV light resistance.

For a lamination constitution, two layers of P1/P2 layer or three layers of P2/P1/P2 is a preferred embodiment because the adhesion to the ethylene-vinyl acetate copolymer (EVA) described below can be maintained by arranging the P2 layer, which contains a small amount of inorganic particles, as an outermost layer.

As the polyester (A2), the high melting point resin (B2), and the inorganic particles (C2), those of the same type as the polyester (A1), the high melting point resin (B1), and the inorganic particles (C1) mentioned above can be suitably used, respectively. Further, as a method of allowing a dispersion phase composed of the high melting point resin (B2) to be present in the polyester (A2), the above-mentioned method of allowing a dispersion phase composed of the high melting point resin (B1) to be present in the polyester (A1) can be suitably used.

In the present invention, it is particularly preferred that, in the P2 layer, 70% or more of the total number of the above-described inorganic particles (C2) be present in the above-described dispersion phases or in contact with the above-described dispersion phases. Also as a method of allowing 70% or more of the total number of the above-described inorganic particles (C2), in the P2 layer, to be present or the like in the above-described dispersion phases, the above-mentioned method can be suitably used.

In the description below, M2 refers to a masterpellet (M2) obtained by melt kneading in advance the inorganic particles (C2) and the high melting point resin (B2); $\eta_{M2}$ refers to the melt viscosity of the masterpellet (M2) (poise) (provided that the melt temperature is the extrusion temperature during melt film forming, Tc (°C)); $Tm_{B2}$ refers to the melting point (°C) of the high melting point resin (B2).

In the present invention, preferred is a combination of the polyester (A1) comprising as a main component either ethylene terephthalate and the high melting point resin (B1) which is any of the polyester resin containing 1,4-cyclohexylenedimethylene terephthalate units in an amount of 93 mol% or more, the polyester resin comprising as a main constituent ethylene-2,6-naphthalenedicarboxylate units, or the resin comprising phenylene sulfide as a main constituent.

In the method of producing the biaxially oriented polyester film of the present invention, the high melting point resin (B1) and the inorganic particles (C1) are melt kneaded to produce a masterpellet (M1); and the polyester (A1) and the masterpellet (M1) are then melt kneaded, extruded into sheet form, and then biaxially oriented to obtain a biaxially oriented polyester film. In the melt kneading of the polyester (A1) and the masterpellet (M1) in a series of these processes, it is preferable to employ the conditions satisfying any of (i), (ii), (iii), (iv) below. By employing such conditions, the effect of improving the hydrolysis resistance and the effect of improving the UV light resistance or the like of the biaxially oriented polyester film finally obtained can be equalized.

Here, the melt viscosity of the polyester (A1) is $\eta_A$; the melt viscosity of the masterpellet (M1) is $\eta_{M1}$; $Tm_{B1}$ is the melting point (°C) of the high melting point resin (B1), Tc is the extrusion temperature (°C) during melt film forming; and $\eta_A$ and $\eta_{M1}$ are the melt viscosity of the polyester (A1) and the masterpellet (M1), respectively, at a temperature of Tc (°C) and a shear rate of 200 sec$^{-1}$.

$$\eta_A/\eta_{M1} \geq 0.2 \quad (i)$$

$$\eta_A/\eta_{M1} \leq 1.0 \quad (ii)$$

$$\eta_A/\eta_{M1} \geq -0.16 \times (Tc - Tm_{B1}) + 2.6 \quad (iii)$$

$$\eta_A/\eta_{M1} \leq -0.08 \times (Tc - Tm_{B1}) + 2.6 \quad (iv)$$

The polyester film of the present invention needs to be a biaxially orientated film. Biaxial orientation effectively forms orientationally crystallized portions, thereby further enhancing the hydrolysis resistance. Biaxial orientation can be achieved by stretching a film biaxially. Examples of stretching methods which can be used include sequential biaxial stretching method (a stretching method combining one-directional stretchings, such as a method in which stretching is performed in the transverse direction after stretching in the machine direction), simultaneous biaxial stretching method (a method in which stretching is performed simultaneously in the machine direction and the transverse direction), or a combination thereof, any of which can be preferably used in the present invention. In addition, stretching a film biaxially by these stretching methods provides not only improved productivity but also mechanical strength and good planarity.

The film thickness of the present invention is preferably not less than 1,000 nm (1 μm) and not more than 200,000 nm (200 μm), more preferably not less than 3,000 nm (3 μm) and not more than 150,000 nm (150 μm), and especially preferably not less than 5,000 nm (5 μm) and not more than 100,000 nm (100 μm). The thickness of the biaxially oriented polyester film of the present invention of not less than 1,000 nm (1 μm) and not more than 200,000 nm (200 μm) provides the film with good hydrolysis resistance and handleability as well as good planarity. In particular, when the particles having UV absorptivity are contained, the UV light resistance will not be poor because the film thickness is not too thin. On the other hand, when used as a solar battery back sheet, the total thickness of the solar battery cell will not be too thick.

Further, the biaxially oriented polyester film of the present invention may contain other additives (for example, organic particles, a heat-resistant stabilizer, an UV absorber, a weathering stabilizer, an organic lubricant, a pigment, a dye, a filler, an antistat, a nucleating agent, and the like) as long as the effects of the present invention are not impaired.

The biaxially oriented polyester film of the present invention preferably has a tensile elongation retention after treatment under an atmosphere at a temperature of 125°C and a humidity of 100% RH for 48 hr of 50%, more preferably 55% or more, still more preferably 60% or more, and most preferably 70% or more. Within such a range, the hydrolysis resistance of the film becomes even better.

Further, tensile elongation retention after irradiation treatment with metal halide lamps with an intensity of 100 mW/cm$^2$ (wavelength range: 295 nm to 450 nm, peak wavelength: 365 nm) under an atmosphere at a temperature of 60°C and 50% RH for 48 hr is preferably 10% or more, more preferably 15% or more, still more preferably 25% or more, and most preferably 35% or more. When the polyester film of the present invention is irradiated with metal halide lamps, particularly in the case where the polyester film is laminated on the other film, the irradiation is carried out such that the side of the biaxially orientated film of the present invention is exposed. Within such a range, the film has good UV light resistance.

Furthermore, since the film whose tensile elongation retention after treatment under an atmosphere at a temperature of 125°C and a humidity of 100% RH for 48 hr and tensile elongation retention after irradiation treatment with metal halide lamps with an intensity of 100 mW/cm$^2$ under an atmosphere at a temperature of 60°C and 50% RH for 48 hr are both in the above-described preferred range has an excellent hydrolysis resistance and UV light resistance, it maintains the mechanical strength over a long period of time also when used as a solar battery back sheet, for example.

From the standpoint of improving the durability of change in color tone due to UV irradiation, Δb after irradiation treatment with metal halide lamps with an intensity of 100 mW/cm$^2$ (wavelength range: 295 nm to 450 nm, peak wavelength: 365 nm) under an atmosphere at a temperature of 60°C and 50% RH for 48 hr is preferably not more than 10, more preferably not more than 6, and still more preferably not more than 3. Δb is measured by the Method for evaluating the properties (8) described below. When Δb is not more than 10, a film having more excellent durability of change in color tone due to UV irradiation can be obtained.

The biaxially oriented polyester film of the present invention has hydrolysis resistance and simultaneously achieves other properties such as UV light resistance and light reflectivity. Therefore, it can be used in such applications where long-term durability is regarded as important and suitably used particularly as a film for a solar battery back sheet.

A solar battery back sheet is composed, for example, of the biaxially oriented polyester film of the present invention, an EVA adhesive layer for improving adhesion to an ethylene-vinyl acetate copolymer (hereinafter also referred to as EVA for short), an anchor layer for enhancing adhesion to the EVA adhesive layer, a water vapor barrier layer, a UV-absorbing layer for absorbing UV light, a light-reflecting layer for enhancing generation efficiency, a light-absorbing layer for expressing a design, an adhesive layer for bonding each layer, and the like, and, in particular, the biaxially oriented polyester film of the present invention can be suitably used as a UV-absorbing layer, a light-reflecting layer, and a light-absorbing layer.

By combining each layer described above with the biaxially oriented polyester film of the present invention, the solar battery back sheet of the present invention is formed. In the solar battery back sheet of the present invention, all the above-mentioned layers need not be formed as an independent layer, and it is also a preferred embodiment to form the layers as a functionally integrated layer combining multiple functions. Further, when the biaxially oriented polyester film of the present invention already has a necessary function, other layers for imparting the function can be omitted. For example, in the case where the biaxially oriented polyester film of the present invention comprises a layer containing a white color pigment and bubbles and has light reflectivity, the light-reflecting layer can be omitted; in the case where the film comprises a layer containing a light absorber and has light absorbency, the absorbing layer can be omitted; and in the case where the film comprises a layer containing an UV absorber, the UV-absorbing layer can be omitted, as the case may be.

The solar battery back sheet using the biaxially oriented polyester film of the present invention preferably has a tensile elongation retention after being left to stand under an atmosphere at a temperature of 125°C and a humidity of 100% RH for 48 hr of 50% or more, more preferably 55% or more, still more preferably 60% or more, and most preferably 70% or more. In the biaxially oriented polyester film of the present invention, if the tensile elongation retention after being left to stand under an atmosphere at a temperature of 125°C and a humidity of 100% RH for 48 hr is 50% or more, for example, the deterioration due to heat and humidity hardly proceeds when a solar battery equipped with the back sheet is used for a long period of time, and even when some external impacts are applied to the solar battery (for example, when a falling rock hits the solar battery), the back sheet will not break.

The solar battery back sheet using the biaxially oriented polyester film of the present invention preferably has a tensile elongation retention after irradiation with metal halide lamps with an intensity of 100 mW/cm$^2$ (wavelength range: 295 nm to 450 nm, peak wavelength: 365 nm) under an atmosphere at a temperature of 60°C and 50% RH for 48 hr of 10% or more, more preferably 15% or more, still more preferably 25% or more, and most preferably 35% or more. When the solar battery back sheet using the biaxially oriented polyester film of the present invention is irradiated with UV light, particularly in the case where the polyester film of the present invention is laminated on the other film, the irradiation is carried out such that the side of the biaxially orientated polyester film of the present invention is exposed to the UV light. If the tensile elongation retention after irradiation with metal halide lamps with an intensity of 100 mW/cm$^2$ under an atmosphere at a temperature of 60°C and 50% RH for 48 hr is not less than 10%, for example, the deterioration due to UV light hardly proceeds when a solar battery equipped with the back sheet is used for a long period of time, and when some external impacts are applied to the solar battery (for example, when a falling rock hits the solar battery), the back sheet will not break.

For the biaxially oriented polyester film of the present invention to exert its effects of high hydrolysis resistance and UV light resistance when used in a solar battery back sheet, the volume percent of the film of the present invention relative to the total solar battery back sheet is preferably not less than 5%, more preferably not less than 10%, still more preferably not less than 15%, and especially preferably not less than 20%.

In addition, in the present invention, the biaxially oriented polyester film of the present invention is preferably provided at at least one outermost side of the solar battery back sheet. Further, it is preferable to arrange the P1 layer at at least one outermost layer of the solar battery back sheet. In such an embodiment, hydrolysis resistance and UV light resistance can be maximally exerted.

The solar battery of the present invention is characterized by using a solar battery back sheet comprising the biaxially oriented polyester film of the present invention as a component. The solar battery back sheet comprising the biaxially oriented polyester film of the present invention as a component can provide a highly durable and thin solar battery compared to conventional solar batteries by exploiting the characteristic in that it is more excellent than conventional back sheets in hydrolysis resistance and other functions, particularly, change resistance in color tone after UV irradiation. The constitution thereof is illustrated in FIG. 1. The solar battery is constituted in such a manner that an electric generating element connected to a lead wire for drawing electricity (not shown in FIG. 1) is sealed with a clear transparent filler agent 2 such as an EVA resin, and a transparent substrate 4 such as glass and a solar battery back sheet 1 are laminated thereon. However, the constitution is not limited thereto, and any constitution may be used.

An electric generating element 3, which converts the light energy of a sunlight 5 into electrical energy, can be used in series or parallel connection with any element, optionally a plurality of elements depending on the desired voltage or current, such as crystalline silicon-based elements, polycrystalline silicon-based elements, microcrystalline silicon-based elements, amorphous silicon-based elements, copper indium selenide-based elements, compound semiconductor-based elements, and dye sensitizer-based elements, depending on the purpose.

The transparent substrate 4 having translucency is arranged at an outermost layer of the solar battery, and therefore transparent materials having not only high transmittance but also high weatherability, high stain resistance, and high mechanical strength properties are used. In the solar battery of the present invention, any material can be used for the transparent substrate 4 having translucency as long as it satisfies the above-described properties, and preferred examples of the materials include glass; fluorine resins such as tetrafluoroethylene-ethylene copolymer (ETFE), polyvinyl fluoride resin (PVF), polyvinylidene fluoride resin (PVDF), polytetrafluoroethylene resin (TFE), tetrafluoroethylene-hexafluoropropylene copolymer (FEP), polychlorotrifluoroethylene resin (CTFE), and polyvinylidene fluoride resin: olefin resins; acrylic resins; and mixtures thereof. In the case of glass, it is more preferable to use tempered one. In the case where a translucent substrate made of a resin is used, resins obtained by uniaxially or biaxially orienting the above-described resins are also preferably used from the standpoint of mechanical strength.

In addition, it is also preferable to subject the surface of these substrates to corona treatment, plasma treatment, ozone treatment, or adhesive treatment in order to provide adhesion to an EVA resin that serves as a sealing material agent for the electric generating element.

The transparent filler agent 2 for sealing the electric generating element is not only for the purpose of electrical insulation by coating and fixing projections and depressions on the surface of the electric generating element with a resin to protect the electric generating element from the external environment, but it also adheres to the substrate having translucency, the back sheet, and the electric generating element. Therefore materials having high transparency, high weatherability, high adhesion, and high heat resistance are used. Examples thereof that are preferably used include ethylene-vinyl acetate copolymer (EVA), ethylene-methyl acrylate copolymer (EMA), ethylene-ethyl acrylate copolymer (EEA) resin, ethylene-methacryl acid copolymer (EMAA), ionomer resin, polyvinyl butyral resin, and mixtures thereof. Among these resins, ethylene-vinyl acetate is more preferably used in terms of excellent balance of weatherability, adhesion, repletion, heat resistance, cold resistance, and shock resistance.

As described above, by incorporating the solar battery back sheet using the biaxially oriented polyester film of the present invention into a solar battery system, a solar battery system that is highly durable and/or thin compared to conventional solar batteries can be achieved. The solar battery of the present invention can be suitably used for various applications, without limitation to outdoor applications or indoor applications, such as a photovoltaic system and a power source for small electronic parts.

[Methods for evaluating the properties]

(1) Melting point of polyester (A1), and high melting point resin (B1),

In accordance with JIS K7122 (1987), the melting point of a resin, Tm, was measured using a differential scanning calorimetry robot DSC-RDC220 manufactured by Seiko Instrument Inc. and "Disk session" SSC/5200 for data analysis. Measurements were made in such a manner that 5 mg of a resin was weighed into a sample pan; the resin was heated from 25°C to 320°C at a temperature rise rate of 20°C/min as 1st RUN, held there for 5 minutes, and then rapidly cooled to 25°C or lower; and the temperature was raised again from room temperature to 320°C at a temperature rise rate of 20°C/min as 2nd Run. The obtained peak top temperature at the crystal melting peak in the 2nd Run was taken as the melting point Tm.

(2) Melt viscosity $\eta_A$, melt viscosity $\eta_{m1}$, melt viscosity $\eta_{M2}$

Measurements were made by Shimadzu Flow Tester CFT-500A manufactured by Shimadzu Corporation using a resin dried in a vacuum oven under reduced pressure at 180°C for 3 hours or more. The amount of the resin is about 5 g, and the melt temperature is set at the same temperature as the extrusion temperature during film forming. Using loads of 10 N, 30 N, and 50 N (loading was started after 5 minutes from the start of sample setting), the shear rate and melt viscosity at each load were determined. The die was of $\varphi$ 1 mm and L = 10 mm. The number of the measurements was three times for each load, and each mean value was determined. The obtained numerical data of the melt viscosity and shear rate at each load were graphed, and the value at a shear rate of 200 sec$^{-1}$ was determined from the graph.

(3) The number of dispersion phase per a unit of a length of 1,000 nm (1 $\mu$m) in the thickness direction of film

Using a microtome, observation samples in the form of a thin film section were prepared without crushing the film cross section in the thickness direction. Two types of samples were prepared: an MD cross-sectional thin film section taken parallel to the machine direction (MD) direction of the film and a TD cross-sectional thin film section taken parallel to the transverse direction (TD) direction.

Next, the cross-sectional thin film section obtained was observed using a transmission electron microscope (TEM) (transmission electron microscope H-7100FA manufactured by Hitachi Ltd.) to obtain an image scaled up 10,000 times. When it was difficult to distinguish a dispersion phase in the image, the film was prestained using, for example, osmic acid or ruthenium oxide as appropriate to carry out the observation.

Using the image obtained above, the number of the dispersion phase composed of the high melting point resin (B1) per a unit of the film thickness of 1,000 nm (1 $\mu$m) was determined. For five points randomly determined in the film, the number was determined individually, and the mean value was taken as the number of the dispersion phase per a unit of a length of 1,000 nm (1 $\mu$m) in the thickness direction of the film. If the number of the dispersion phases per a unit of 1,000 nm (1 $\mu$m) is one or more, then a dispersion phases shall be deemed to exist.

(4) Distribution of inorganic particles

The number of all the inorganic particles in the observed image scaled up 50,000 times obtained by the same method as in the section (3) above was counted and taken as the total number N, and among the particles, the number of the particles present in the dispersion phases composed of the high melting point resin (B1) or in contact with the dispersion phases, Nb, was determined. Using each value obtained, the percentage of the particles present in the dispersion phases composed of the high melting point resin (B1) or in contact with dispersion phasse relative to the total number of the particles present in the film, Nb / N $\times$ 100 (%), was calculated. For five points randomly determined in the polyester layer, the percentage was determined individually, and the mean value was taken as the percentage of the particles.

(5) Measurement of tensile elongation at break

According to ASTM-D882 (1999), a sample was cut out to a size of 10 mm × 200 mm, the tensile elongation at break when pulled at a chuck distance of 5 mm and a tensile speed of 300 mm/min was measured. For the number of the samples, n = 5, and after the measurements for both the longitudinal direction and the transverse direction of the film, the tensile elongation at break was determined as the mean value thereof.

(6) Tensile elongation retention after moist-heat resistance test

A sample was cut out into the shape of a measurement strip (10 mm × 200 mm), and then treated in a pressure cooker manufactured by Tabai Espec Corporation under conditions at a temperature of 125°C and 100% RH for 48 hr, after which the tensile elongation at break was measured according to the section (5) above. In the measurements, n = 5, and after the measurements were made for both the longitudinal direction and the transverse direction of the film, the mean value thereof was taken as the tensile elongation at break $E_1$. Further, for the film before treatment, the tensile elongation at break $E_0$ was measured according to the section (5) above, and the obtained tensile elongations at break $E_0$ and $E_1$ were used to calculate the tensile elongation retention by the following equation.

$$\text{Tensile elongation retention (\%)} = E_1 / E_0 \times 100$$

If the tensile elongation retention is 50% or more, the film can be suitably used as a film for a solar battery back sheet. More preferred is 55% or more, still more preferred is 60% or more, and most preferred is 70% or more.

(7) Tensile elongation retention after weathering test

A sample was cut out into the shape of a measurement strip (1cm × 20cm), and then irradiated in EYE Super UV tester, SUV-W131, manufactured by IWASAKI ELECTRIC CO., LTD. under conditions at a temperature of 60°C, a relative humidity of 60% RH, and an illuminance of 100 mW/cm$^2$ (light source: metal halide lamps, wavelength range: 295 nm to 450 nm, peak wavelength: 365 nm) for 48 hours, after which the tensile elongation at break was measured according to the section (5) above. In the measurements, n = 5, and after the measurements were made for both the longitudinal direction and the transverse direction of the film, the mean value thereof was taken as the tensile elongation at break $E_2$. Further, also for the film before treatment, the tensile elongation at break $E_0$ was measured according to the section (5) above, and the tensile elongations at break $E_0$ and $E_2$ thus obtained were used to calculate the tensile elongation retention by the following equation.

$$\text{Tensile elongation retention (\%)} = E_2 / E_0 \times 100$$

When the film is a laminated film, the side of the biaxially oriented polyester film of the present invention is irradiated with UV light.

(8) Δb

A sample was cut out into the shape of a measurement strip (10 mm × 200 mm), and then irradiated in EYE Super UV tester, SUV-W131, manufactured by IWASAKI ELECTRIC CO., LTD. under conditions at a temperature of 60°C, a relative humidity of 60% RH, and an illuminance of 100 mW/cm$^2$ (light source: metal halide lamps, wavelength range: 295 nm to 450 nm, peak wavelength: 365 nm) for 48 hr. The b value of the P1 layer in reflectance mode was measured in accordance with JIS Z 8722 (2000) using a spectral color difference meter, model SE-2000 (manufactured by NIPPON DENSHOKU INDUSTORIES CO., LTD.). For the number of the samples, n = 5, and each b value was measured to calculate the mean value thereof. The sample measurement diameter was 30 mm φ. Taking the b value of the film before UV irradiation treatment as $K_0$, and the b value after the above-described treatment as K; Δb was calculated by the following equation.

$$\Delta b = K - K_0$$

(9) Method of measuring weight-average molecular weight

First, the weight-average molecular weight was determined using as a detector a refractive index detector, RI (model RI-8020, sensitivity: 32), manufactured by SHOWA DENKO K.K. and as a column a gel permeation chromatograph, GPC (16), available from TOSOH CORPORATION equipped with two TSK gel GMHHR-M ($\varphi$: 7.8 mm $\times$ 300 mm, theoretical plate number: 14,000 plates) available from TOSOH CORPORATION. As a moving bed, a solvent in which the polyester (A1) and the high melting point resin (B1) are both soluble is most preferably used, and since the polyester (A1) in the present invention is a resin comprising as a main component polyethylene terephthalate, examples of solvents include, for example, chlorophenol, chloroform, hexafluoroisopropanol, and 1-chloronaphthalene. When the high melting point resin (B1) or is not soluble in the above-mentioned solvent, a solvent in which they are soluble may be used, and when they are not readily soluble, the dissolution may be promoted, for example, by raising the temperature of the solvent as appropriate. Next, the flow rate of the moving bed was 1.0 mL/min; the column temperature was 23°C $\pm$ 2°C; and the injection volume was 0.200 mL. Here, monodisperse polystyrene (TSK standard polystyrene available from TOSOH CORPORATION) was used as a standard sample, and the relative value to the polystyrene was used. This relative value was taken as the weight-average molecular weight.

(10) Method of measuring longitudinal length of dispersion phases

(a) Observed images scaled up 500 to 5,000 times obtained by the same method as in the section (3) above were obtained to observe the cross section such that the total cross-sectional area of the polyester layer (P1 layer) is 3 $\times$ $10^9$ nm$^2$ (3,000 $\mu$m$^2$). When 3 $\times$ $10^9$ nm$^2$ (3,000 $\mu$m$^2$) is not satisfied at two points in the MD and TD cross-sectional image because the thickness of the polyester layer (P1 layer) is thin, a plurality of cross sections may be used to observe such that 3 $\times$ $10^9$ nm$^2$ (3,000 $\mu$m$^2$) is satisfied in total.
(b) For all the dispersion phases composed of the high melting point resin (B1) contained in the image obtained, the longitudinal length is individually measured. Here, the two points having the longest straight-line distance therebetween in the dispersion phase is determined, and the straight-line length between the two points is employed as the longitudinal length of the dispersion phase.
(c) The number of the dispersion phases of more than 30,000 nm (30 $\mu$m) among all the longitudinal length obtained in the above (b) is counted. (13) Method of measuring average longitudinal length of dispersion phase
(d) Observed images scaled up 5,000 times obtained by the same method as in the section (3) above are obtained. Observation points are three or more points randomly determined in the polyester layer (P1 layer) (i.e., three or more images can be obtained).
(e) For all the dispersion phases composed of the high melting point resin (B1) contained in the image obtained, the longitudinal length is individually measured. Here, the two points having the longest straight-line distance therebetween in the dispersion phase is determined, and the straight-line length between the two points is employed as the longitudinal length of the dispersion phase.
(f) Also for the TD cross-sectional thin film section, the longitudinal length of each dispersion phase is individually measured by the same method as in (d) and (e).
(g) All the longitudinal length obtained in the above (e) and (f) is averaged to obtain the average longitudinal length.

EXAMPLES

The present invention will now be described by way of examples.

(Preparation of materials)

Polyethylene terephthalate (PET) (polyester (A1))

Using 100 mol% of terephthalic acid as a dicarboxylic acid component and 100 mol% of ethylene glycol as a diol component, a polycondensation reaction was carried out using magnesium acetate, antimony trioxide, and phosphorous acid as a catalyst. Then, the polyethylene terephthalate obtained was dried at 160°C for 6 hours and crystallized, after which a solid phase polymerization at 220°C and a degree of vacuum of 0.3 Torr for 9 hours was carried out to obtain polyethylene terephthalate (PET) having a melting point of 255°C and a melt viscosity $\eta_A$ of 3,500 poise.

Polycyclohexylenedimethylene terephthalate (PCHT/I) (high melting point resin (B1))

Using 95 mol% of terephthalic acid and 5 mol% of isophthalic acid as a dicarboxylic acid component and 100 mol% of cyclohexylenedimethanol as a diol component, a polycondensation reaction was carried out using magnesium acetate, antimony trioxide, and phosphorous acid as a catalyst, to obtain polycyclohexylenedimethylene terephthalate (PCHT/I) containing 5 mol% of isophthalic acid as a copolymer component and having a melting point of 283°C. Polycyclohexylenedimethylene terephthalate (PCHT) (high melting point resin (B1))

Using 100 mol% of terephthalic acid as a dicarboxylic acid component and 100 mol% of cyclohexylenedimethanol as a diol component, a polycondensation reaction was carried out using magnesium acetate, antimony trioxide, and phosphorous acid as a catalyst to obtain polycyclohexylenedimethylene terephthalate (PCHT) having a melting point of 290°C.

Polycyclohexylenedimethylene terephthalate (PCHT/G) (high melting point resin (B1))

Using 100 mol% of terephthalic acid as a dicarboxylic acid component and 87 mol% of cyclohexylenedimethanol and 13 mol% of ethylene glycol as a diol component, a polycondensation reaction was carried out using magnesium acetate, antimony trioxide, and phosphorous acid as a catalyst to obtain polycyclohexylenedimethylene terephthalate (PCHT/G) containing as a copolymer component 13 mol% of ethylene glycol and having a melting point of 265°C. Polyethylene-2,6-naphthalenedicarboxylate (PEN) high melting point resin (B1))

To an ester interchange reactor equipped with a mixing device, a rectifying column, and a condenser, added was 100 parts by mass of dimethyl 2,6-naphthalene dicarboxylic acid, 51 parts by mass of ethylene glycol, 0.06 parts by mass of calcium acetate, and 0.025 parts by mass of antimony trioxide. The temperature was gradually raised from 180°C to 240°C, and an ester interchange reaction was carried out while continuously distilling the simultaneously generated methanol out of the reaction system. To the reactant thus obtained, 0.04 parts by mass of trimethyl phosphate ester was added, and the resulting mixture was reacted for 5 minutes. Then, the temperature was raised to 285°C while continuously discharging the ethylene glycol, and the pressure was simultaneously reduced to 0.2 mmHg to carry out a polycondensation reaction, thereby obtaining polyethylene-2,6-naphthalenedicarboxylate (PEN) having an intrinsic viscosity of 0.82.

Polyphenylene sulfide (high melting point resin (B1))

A PPS resin (M3910 available from TORAY INDUSTRIES, INC.) (PPS) was used.

3 mol% 2,6-naphthalene dicarboxylic acid copolymerized PET (PET/N) (high melting point resin (B1))

Used was 3 mol% 2,6-naphthalene dicarboxylic acid copolymerized PET (PET/N) dried at 170°C for 3 hours.

Polyethylene diphenylcarboxylate (PEDPC) (high melting point resin (B1))

Polyethylene diphenylcarboxylate (PEDPC) dried at 180°C for 3 hours was used.

Titanium oxide (inorganic particles C)

Rutile-type titanium oxide particles with an average particle diameter of 200 nm were used.

Barium sulfate (inorganic particles C)

Barium sulfate with an average particle diameter of 700 nm was used.

(Examples 1 to 13, 17 to 29, 33 to 45, 49 to 60, Comparative Examples 1 to 27)

Production of biaxially stretched (biaxially oriented) polyester film

The high melting point resin (B1) and the inorganic particles (C1) shown in Tables 1, 6, 11, and 16 were mixed such that the contents were as shown in Tables 1, 6, 11, and 16, and the resulting mixture was melt kneaded in a vented extruder at a temperature shown below to produce a masterpellet (M1) such that the value of $\eta_A/\eta_{M1}$ was as shown in Tables 1, 6, 11, and 16.

<Extruder temperature during production of masterpellet>

Examples 17 to 29, Examples 53 to 56, Examples 64 to 66, Comparative Example 15, Comparative Example 16, Comparative Example 23, Comparative Example 26: 280°C

Examples 1 to 13, Examples 49 to 52, Examples 61 to 63, Example 70, Example 72, Comparative Examples 1 to 6, Comparative Example 13, Comparative Example 14, Comparative Examples 19 to 22, Comparative Example 25, and Comparative

Example 28: 290°C

Examples 73 and 74: 300°C

Examples 33 to 45, Examples 57 to 60, Examples 67 to 69, Example 71, Comparative Example 17, Comparative Example 18, Comparative Example 24, Comparative Example 27, Comparative Example 30: 310°C

Comparative Examples 7 to 12: 345°C

Then, a pellet of the polyester (A1) vacuum-dried at 180°C for 3 hours shown in Tables 1, 6, 11, and 16 and a masterpellet (M1) vacuum-dried at 180°C for 3 hours were mixed such that the contents were as shown in Tables 1,6, 11, and 16, and the resulting mixture was melt kneaded at an extruder temperature during film forming shown in Tables 1, 6, 11, and 16 and introduced into a T-die.

Then, the resultant was melt extruded from the T-die into sheet form and brought into close contact by electro-pinning with a drum maintained at a surface temperature of 25°C to be cooled to solidify, thereby obtaining a non-oriented monolayer film. Next, the non-oriented monolayer film was preheated with a group of rolls heated to a temperature of 80°C, stretched 3.5-fold in the machine direction (longitudinal direction) using a heating roll at a temperature of 88°C, and cooled with a group of rolls at a temperature of 25°C to obtain a uniaxially stretched film.

The uniaxially stretched film obtained was guided to a preheating zone at a temperature of 90°C in a tenter with both ends held by clips, and then continuously stretched 3.8-fold in the direction perpendicular to the machine direction (the transverse direction) in a heating zone maintained at 100°C. Further, the film was subjected to heat treatment at 220°C for 20 seconds in a heat treatment zone in the tenter, and furthermore relaxed in the transverse direction by 4% at 220°C. Then, the film was uniformly and slowly cooled to obtain a biaxially oriented polyester film with a thickness of 50,000 nm (50 $\mu$m).

The film obtained was evaluated for percentage of the cases where titanium oxide particles were present or the like in the dispersion phases of the high melting point resin (B1), tensile elongation retention after moist-heat resistance test, and tensile elongation retention after weathering test. The results are shown in Tables 2, 5, 7, 10, 12, 15, 17, and 20.

As shown in Tables 5 and 10, the films of Examples 1 to 32 and Examples 49 to 56 proved to be a film having excellent hydrolysis resistance and UV light resistance. In addition, they were films having excellent resistance of change in color tone due to UV irradiation.

As shown in Table 10, the films of Examples 33 to 48 and Examples 57 to 60 were films having excellent hydrolysis resistance and UV light resistance and were excellent especially in hydrolysis resistance. As shown in Table 15, the films of Examples 61 to 69 proved to be films having excellent hydrolysis resistance and UV light resistance. As shown in Table 15, the films of Examples 72 to 74 were films having especially excellent hydrolysis resistance and UV light resistance, wherein the relationships: $x > 94.5$ and $y \times 10^{-3} \leq x - 94.5$ were satisfied. Here, x represents molar fraction (mol%) of 1,4-cyclohexylenedimethylene terephthalate units, and y represents average longitudinal length (nm) of the dispersion phases.

On the other hand, the films of Comparative Examples proved to be poor in the following respects.

The films of Comparative Examples 1 to 6 and Comparative Example 28 were films having poor hydrolysis resistance.

The films of Comparative Examples 7 to 10 were films having poor hydrolysis resistance, wherein the polyester (A1) caused a significant IV reduction in the film forming process because the melting point of the high melting point resin (B1) was over 320°C.

The films of Comparative Examples 1, 2, 7, 8, 13, 15, and 17 were films having poor hydrolysis resistance, wherein the content of the high melting point resin (B1) in the P1 layer were less than 2% by mass.

In Comparative Examples 5, 6, 11, 12, 14, 16, and 18, the content of the high melting point resin (B1) in the P1 layer was over 40% by mass, and therefore the film forming ability was significantly reduced, thereby failing to obtain a film.

The films of Comparative Examples 19 to 21 were films having poor hydrolysis resistance, wherein the dispersion phase composed of the high melting point resin (B1) did not exist, and the particles were dispersed in the polyester (A1) in large amounts.

The films of Comparative Examples 22 to 27 were films having poor $\Delta b$, wherein the number of the dispersion phase having a longitudinal length of more than 30,000 nm (30 $\mu$m) was more than $2/3 \times 10^9$ nm$^2$ (2/3,000 $\mu$m$^2$).

Production of solar battery back sheet

Further, to the film obtained, a biaxially oriented polyester film "Lumirror" (registered trademark) X10S (available from TORAY INDUSTRIES, INC.) with a thickness of 75000 nm (75 μm) was laminated using an adhesive (mixture of 90 parts by mass of "TAKELAC" (registered trademark) A310 (available from Mitsui Takeda Chemical Inc.) and 10 parts by mass of "TAKENATE" (registered trademark) A3 (available from Mitsui Takeda Chemical K.K.)). Further, a gas barrier film "Barrialox" (registered trademark) VM-PET1031HGTS (available from TORAY ADVANCED FILM CO., LTD.) with a thickness of 12,000 nm (12 μm) was laminated to the side of the biaxially oriented polyester film with the above-described adhesive such that a vapor deposition layer was at the outside to produce a solar battery back sheet with a thickness of 188,000 nm (188 μm). The results of the evaluation of the hydrolysis resistance and weatherability of the back sheet obtained are shown in Tables 5, 10, 15, and 20.

As shown in Tables 5, 10, 15, and 20, the solar battery back sheet using the films of Examples proved to have high hydrolysis resistance and UV light resistance.

(Examples 14 to 16, 30 to 32, 46 to 48)

The high melting point resin (B1) and the inorganic particles (C1) shown in Tables 1 and 6 were mixed such that the contents were as shown in Tables 1 and 6, melt kneaded in a vented extruder at a temperature shown below to produce a masterpellet (M1) such that the value of $\eta_A/\eta_{M1}$ was as shown in Table 1 and Table 6.

<Extruder temperature during production of masterpellet (M1)>

Examples 30 to 32: 280°C

Examples 14 to 16: 290°C

Examples 46 to 48: 310°C

The high melting point resin (B2) and the inorganic particles (C2) shown in Table 3 and Table 8 were mixed such that the contents were as shown in Table 3 and Table 8, melt kneaded in a vented extruder at a temperature shown below to produce a masterpellet (M2) such that the value of $\eta_A/\eta_{M2}$ was as shown in Table 3 and Table 8.

<Extruder temperature during production of masterpellet (M2)>

Examples 30 to 32: 280°C

Examples 14 to 16: 290°C

Examples 46 to 48: 310°C

Then, as a material of the P1 layer, a pellet of the polyester (A1) vacuum-dried at 180°C for 3 hours shown in Table 1 and Table 6 and a masterpellet (M1) vacuum-dried at 180°C for 3 hours were mixed such that the contents were as shown in Table 1 and Table 6, and melt kneaded in a main extruder at a temperature shown below; as a material of the P2 layer, a pellet of the polyester (A2) vacuum-dried at 180°C for 3 hours shown in Tables 3 and 8 and a masterpellet (M2) vacuum-dried at 180°C for 3 hours were mixed such that the contents were as shown in Tables 4 and 9, and melt kneaded in a side extruder at a temperature shown below; and these materials were converged using a feed block, a converging device for lamination, to form a two-layer laminate composed of the P1 layer/the P2 layer, and introduced into a T-die.

<Temperature of main and side extruder>

Examples 30 to 32: 280°C

Examples 14 to 16: 300°C

Examples 46 to 48: 315°C

Then, the resultant was melt extruded from the T-die into sheet form and brought into close contact by electro-pinning with a drum maintained at a surface temperature of 25°C to be cooled to solidify, thereby obtaining a non-oriented two-layer laminated film. After this, the film formation was carried out in the same manner as in Example 1 to obtain two-layer biaxially stretched (biaxially oriented) polyester film. The properties and the like of the polyester films obtained are shown in Tables 5 and 10. The films obtained proved to be a film that was excellent especially in hydrolysis resistance and UV light resistance because of the two-layer constitution in which the P1 layer provided with strong UV light resistance and the P2 layer provided with strong hydrolysis resistance are sharing the functions.

Further, using the film obtained, a solar battery back sheet was produced in the same manner as in Example 1 such that the P1 layer of the film was at the outermost side. The properties and the like of the back sheet obtained are shown in Tables 5 and 10. It was shown that the hydrolysis resistance and the UV light resistance were excellent.

[Table 1]

| | Polyester (A1) | High melting point resin (B1) Type | High melting point resin (B1) Melting point Tm (°C) | Extrusion temperature during melt film forming Tc (°C) | tanδpeak temperature (°C) | $(Mw_{A1'}/Mw_{A1'})$ / $(Mw_{B1'}/Mw_{B1})$ or | Inorganic particles (C1) | Masterpellet (M1) B1 content (Parts by mass) | Masterpellet (M1) C1 content (Parts by mass) | Masterpellet (M1) C1 concentration (% by mass) | $\eta_A/\eta_{M1}$ (-) |
|---|---|---|---|---|---|---|---|---|---|---|---|
| Example 1 | PET | PCHT/I | 283 | 300 | 92 | 1.84 | Titanium oxide | 100 | 100 | 50 | 0.42 |
| Example 2 | PET | PCHT/I | 283 | 300 | 92 | 1.84 | Titanium oxide | 100 | 100 | 50 | 0.31 |
| Example 3 | PET | PCHT/I | 283 | 300 | 92 | 1.84 | Titanium oxide | 95 | 5 | 5 | 0.42 |
| Example 4 | PET | PCHT/I | 283 | 300 | 92 | 1.84 | Titanium oxide | 95 | 5 | 5 | 0.31 |
| Example 5 | PET | PCHT/I | 283 | 300 | 92 | 1.84 | Titanium oxide | 61 | 39 | 39 | 0.42 |
| Example 6 | PET | PCHT/I | 283 | 300 | 92 | 1.84 | Titanium oxide | 61 | 39 | 39 | 0.31 |
| Example 7 | PET | PCHT/I | 283 | 300 | 92 | 1.84 | Titanium oxide | 100 | 100 | 50 | 0.39 |
| Example 8 | PET | PCHT/I | 283 | 300 | 92 | 1.84 | Titanium oxide | 100 | 100 | 50 | 0.34 |
| Example 9 | PET | PCHT/I | 283 | 300 | 92 | 1.84 | Titanium oxide | 67 | 33 | 33 | 0.36 |
| Example 10 | PET | PCHT/I | 283 | 300 | 92 | 1.84 | Titanium oxide | 50 | 50 | 50 | 0.36 |
| Example 11 | PET | PCHT/I | 283 | 300 | 92 | 1.84 | Titanium oxide | 40 | 60 | 60 | 0.36 |
| Example 12 | PET | PCHT/I | 283 | 300 | 92 | 1.84 | Titanium oxide | 100 | 100 | 50 | 0.39 |
| Example 13 | PET | PCHT/I | 283 | 300 | 92 | 1.84 | Titanium oxide | 100 | 100 | 50 | 0.34 |

(continued)

| | Polyester (A1) | High melting point resin (B1) | | Extrusion temperature during melt film forming Tc (°C) | $\tan\delta$peak temperature (°C) | $(Mw_{A1'}/Mw_{A1})/(Mw_{B1'}/Mw_{B1})$ or | Inorganic particles (C1) | Masterpellet (M1) | | | $\eta_A/\eta_{M1}$ (-) |
|---|---|---|---|---|---|---|---|---|---|---|---|
| | | Type | Melting point Tm (°C) | | | | | B1 content (Parts by mass) | C1 content (Parts by mass) | C1 concentration (% by mass) | |
| Example 14 | PET | PCHT/I | 283 | 300 | 92 | 1.84 | Titanium oxide | 100 | 100 | 50 | 0.36 |
| Example 15 | PET | PCHT/I | 283 | 300 | 92 | 1.84 | Titanium oxide | 100 | 100 | 50 | 0.36 |
| Example 16 | PET | PCHT/I | 283 | 300 | 92 | 1.84 | Barium sulfate | 100 | 100 | 50 | 0.36 |
| Example 17 | PET | PEN | 263 | 280 | 125 | 1.90 | Titanium oxide | 100 | 100 | 50 | 0.55 |
| Example 18 | PET | PEN | 263 | 280 | 125 | 1.90 | Titanium oxide | 100 | 100 | 50 | 0.44 |
| Example 19 | PET | PEN | 263 | 280 | 125 | 1.90 | Titanium oxide | 93 | 7 | 7 | 0.55 |
| Example 20 | PET | PEN | 263 | 280 | 125 | 1.90 | Titanium oxide | 93 | 7 | 7 | 0.44 |
| Example 21 | PET | PEN | 263 | 280 | 125 | 1.90 | Titanium oxide | 61 | 39 | 39 | 0.55 |
| Example 22 | PET | PEN | 263 | 280 | 125 | 1.90 | Titanium oxide | 61 | 39 | 39 | 0.44 |
| Example 23 | PET | PEN | 263 | 280 | 125 | 1.90 | Titanium oxide | 100 | 100 | 50 | 0.52 |
| Example 24 | PET | PEN | 263 | 280 | 125 | 1.90 | Titanium oxide | 100 | 100 | 50 | 0.47 |
| Example 25 | PET | PEN | 263 | 280 | 125 | 1.90 | Titanium oxide | 67 | 33 | 33 | 0.49 |
| Example 26 | PET | PEN | 263 | 280 | 125 | 1.90 | Titanium oxide | 100 | 100 | 50 | 0.49 |

(continued)

| | Polyester (A1) | High melting point resin (B1) | | Extrusion temperature during melt film forming Tc (°C) | tanδpeak temperature (°C) | $(Mw_{A1'}/Mw_{A1})/(Mw_{B1'}/Mw_{B1})$ or | Inorganic particles (C1) | Masterpellet (M1) | | | $\eta_A/\eta_{M1}$ (-) |
| | | Type | Melting point Tm (°C) | | | | | B1 content (Parts by mass) | C1 content (Parts by mass) | C1 concentration (% by mass) | |
|---|---|---|---|---|---|---|---|---|---|---|---|
| Example 27 | PET | PEN | 263 | 280 | 125 | 1.90 | Titanium oxide | 40 | 60 | 60 | 0.49 |
| Example 28 | PET | PEN | 263 | 280 | 125 | 1.90 | Titanium oxide | 100 | 100 | 50 | 0.52 |
| Example 29 | PET | PEN | 263 | 280 | 125 | 1.90 | Titanium oxide | 100 | 100 | 50 | 0.47 |

[Table 2]

| | P1 layer | | | | | | | | |
|---|---|---|---|---|---|---|---|---|---|
| | Al content (Parts by mass) | MI content (Parts by mass) | B1 concentration $W_{B1}$ (% by mass) | C1 concentration $W_{C1}$ (% by mass) | Presence or absence of despersion phases | The number of the dispersion phases of more than 30,000nm (30 $\mu$m) | Longitudinal length of dispersion phases ($10^3$ nm) | Percentage of the number of C1 being present or the like in dispersion phases (%) | Thickness ($10^3$ nm) |
| Example 1 | 96 | 4 | 2 | 2 | presence | 0 | 5 | 70 | 50 |
| Example 2 | 96 | 4 | 2 | 2 | presence | 0 | 7 | 95 | 50 |
| Example 3 | 58 | 42 | 40 | 2 | presence | 0 | 5 | 70 | 50 |
| Example 4 | 58 | 42 | 40 | 2 | presence | 0 | 7 | 95 | 50 |
| Example 5 | 35 | 65 | 40 | 25 | presence | 0 | 5 | 70 | 50 |
| Example 6 | 35 | 65 | 40 | 25 | presence | 0 | 7 | 95 | 50 |
| Example 7 | 94 | 6 | 3 | 3 | presence | 0 | 6 | 80 | 50 |
| Example 8 | 94 | 6 | 3 | 3 | presence | 0 | 6 | 90 | 50 |
| Example 9 | 94 | 6 | 4 | 2 | presence | 0 | 6 | 85 | 50 |
| Example 10 | 92 | 8 | 4 | 4 | presence | 0 | 6 | 85 | 50 |
| Example 11 | 90 | 10 | 4 | 6 | presence | 0 | 6 | 85 | 50 |
| Example 12 | 50 | 50 | 25 | 25 | presence | 0 | 6 | 80 | 50 |
| Example 13 | 50 | 50 | 25 | 25 | presence | 0 | 6 | 90 | 50 |

(continued)

| | Al content (Parts by mass) | Ml content (Parts by mass) | B1 concentration $W_{B1}$ (% by mass) | C1 concentration $W_{C1}$ (% by mass) | P1 layer | | | | |
| --- | --- | --- | --- | --- | --- | --- | --- | --- | --- |
| | | | | | Presence or absence of despersion phases | The number of the dispersion phases of more than 30,000nm (30 μm) | Longitudinal length of dispersion phases ($10^3$ nm) | Percentage of the number of C1 being present or the like in dispersion phases (%) | Thickness ($10^3$ nm) |
| Example 14 | 64 | 36 | 18 | 18 | presence | 0 | 6 | 85 | 7.5 |
| Example 15 | 64 | 36 | 18 | 18 | presence | 0 | 6 | 85 | 7.5 |
| Example 16 | 64 | 36 | 18 | 18 | presence | 0 | 6 | 85 | 7.5 |
| Example 17 | 96 | 4 | 2 | 2 | presence | 0 | 4 | 70 | 50 |
| Example 18 | 96 | 4 | 2 | 2 | presence | 0 | 6 | 95 | 50 |
| Example 19 | 58 | 42 | 40 | 2 | presence | 0 | 4 | 70 | 50 |
| Example 20 | 58 | 42 | 40 | 2 | presence | 0 | 6 | 95 | 50 |
| Example 21 | 35 | 65 | 40 | 25 | presence | 0 | 4 | 70 | 50 |
| Example 22 | 35 | 65 | 40 | 25 | presence | 0 | 6 | 95 | 50 |
| Example 23 | 94 | 6 | 3 | 3 | presence | 0 | 4 | 80 | 50 |
| Example 24 | 94 | 6 | 3 | 3 | presence | 0 | 5 | 90 | 50 |
| Example 25 | 94 | 6 | 4 | 2 | presence | 0 | 5 | 85 | 50 |
| Example 26 | 92 | 8 | 4 | 4 | presence | 0 | 5 | 85 | 50 |

(continued)

| | P1 layer | | | | | | | | |
| --- | --- | --- | --- | --- | --- | --- | --- | --- | --- |
| | AI content (Parts by mass) | MI content (Parts by mass) | B1 concentration $W_{B1}$ (% by mass) | C1 concentration $W_{C1}$ (% by mass) | Presence or absence of despersion phases | The number of the dispersion phases of more than 30,000nm (30 $\mu$m) | Longitudinal length of dispersion phases ($10^3$ nm) | Percentage of the number of C1 being present or the like in dispersion phases (%) | Thickness ($10^3$ nm) |
| Example 27 | 90 | 10 | 4 | 6 | presence | 0 | 5 | 85 | 50 |
| Example 28 | 50 | 50 | 25 | 25 | presence | 0 | 4 | 80 | 50 |
| Example 29 | 50 | 50 | 25 | 25 | presence | 0 | 5 | 90 | 50 |

[Table 3]

| | Polyester (A2) | High melting point resin (B2). | | Inorganic particles (C2) | Masterpellet (M2) | | | $\eta_A/\eta_{M2}$ (-) |
| | | Type | Melting point Tm (°C) | | B2 content (Parts by mass) | C2 content (Parts by mass) | C2 concentration (% by mass) | |
|---|---|---|---|---|---|---|---|---|
| Example 1 | - | - | - | - | - | - | - | - |
| Example 2 | - | - | - | - | - | - | - | - |
| Example 3 | - | - | - | - | - | - | - | - |
| Example 4 | - | - | - | - | - | - | - | - |
| Example 5 | - | - | - | - | - | - | - | - |
| Example 6 | - | - | - | - | - | - | - | - |
| Example 7 | - | - | - | - | - | - | - | - |
| Example 8 | - | - | - | - | - | - | - | - |
| Example 9 | - | - | - | - | - | - | - | - |
| Example 10 | - | - | - | - | - | - | - | - |
| Example 11 | - | - | - | - | - | - | - | - |
| Example 12 | - | - | - | - | - | - | - | - |
| Examples 13 | - | - | - | - | - | - | - | - |
| Example 14 | PET | PCHT | 283 | Titanium oxide | 100 | 100 | 50 | 0.36 |
| Example 15 | PET | PCHT | 283 | Titanium oxide | 100 | 100 | 50 | 0.36 |
| Example 16 | PET | PCHT | 283 | Barium sulfate | 100 | 100 | 50 | 0.36 |
| Example 17 | - | - | - | - | - | - | - | - |
| Example 18 | - | - | - | - | - | - | - | - |
| Example 19 | - | - | - | - | - | - | - | - |
| Example 20 | - | - | - | - | - | - | - | - |
| Example 21 | - | - | - | - | - | - | - | - |
| Example 22 | - | - | - | - | - | - | - | - |
| Example 23 | - | - | - | - | - | - | - | - |
| Example 24 | - | - | - | - | - | - | - | - |

(continued)

| | Polyester (A2) | High melting point resin (B2). | | Inorganic particles (C2) | Masterpellet (M2) | | | $\eta_A/\eta_{M2}$ (-) |
| | | Type | Melting point Tm (°C) | | B2 content (Parts by mass) | C2 content (Parts by mass) | C2 concentration (% by mass) | |
|---|---|---|---|---|---|---|---|---|
| Example 25 | - | - | - | - | - | - | - | - |
| Example 26 | - | - | - | - | - | - | - | - |
| Example 27 | - | - | - | - | - | - | - | - |
| Example 28 | - | - | - | - | - | - | - | - |
| Example 29 | - | - | - | - | - | - | - | - |

[Table 4]

| | P2 layer | | | | | | Laminated film | | |
|---|---|---|---|---|---|---|---|---|---|
| | A2 content (Parts by mass) | M2 content (Parts by mass) | B2 concentration $W_{B2}$ (% by mass) | C2 concentration $W_{C2}$ (% by mass) | Presence or absence of dispersion phases | Percentage of the number of C2 being present or the like in dispersion phases | Thickness $(10^3 nm)$ | Laminated ratio | $W_{C1} - W_{C2}$ |
| Example 1 | - | - | - | - | - | - | - | - | - |
| Example 2 | - | - | - | - | - | - | - | - | - |
| Example 3 | - | - | - | - | - | - | - | - | - |
| Example 4 | - | - | - | - | - | - | - | - | - |
| Example 5 | - | - | - | - | - | - | - | - | - |
| Example 6 | - | - | - | - | - | - | - | - | - |
| Example 7 | - | - | - | - | - | - | - | - | - |
| Example 8 | - | - | - | - | - | - | - | - | - |
| Example 9 | - | - | - | - | - | - | - | - | - |
| Example 10 | - | - | - | - | - | - | - | - | - |
| Example 11 | - | - | - | - | - | - | - | - | - |
| Example 12 | - | - | - | - | - | - | - | - | - |
| Example 13 | - | - | - | - | - | - | - | - | - |

| | P2 layer | | | | | | | Laminated film | |
| --- | --- | --- | --- | --- | --- | --- | --- | --- | --- |
| | A2 content (Parts by mass) | M2 content (Parts by mass) | B2 concentration $W_B2$ (% by mass) | C2 concentration $W_{C2}$ (% by mass) | Presence or absence of dispersion phases | Percentage of the number of C2 being present or the like in dispersion phases | Thickness ($10^3$nm) | Laminated ratio | $W_{C1}$ - $W_{C2}$ |
| Example 14 | 99 | 1 | 0.5 | 0.5 | presence | 85 | 42.5 | 1 : 6 | 17.5 |
| Example 15 | 97 | 3 | 1.5 | 1.5 | presence | 85 | 42.5 | 1 : 6 | 16.5 |
| Example 16 | 97 | 3 | 1.5 | 1.5 | presence | 85 | 42.5 | 1 : 6 | 16.5 |
| Example 17 | - | - | - | - | - | - | - | - | - |
| Example 18 | - | - | - | - | - | - | - | - | - |
| Example 19 | - | - | - | - | - | - | - | - | - |
| Example 20 | - | - | - | - | - | - | - | - | - |
| Example 21 | - | - | - | - | - | - | - | - | - |
| Example 22 | - | - | - | - | - | - | - | - | - |
| Example 23 | - | - | - | - | - | - | - | - | - |
| Example 24 | - | - | - | - | - | - | - | - | - |
| Example 25 | - | - | - | - | - | - | - | - | - |
| Example 26 | - | - | - | - | - | - | - | - | - |

EP 2 495 284 B1

28

(continued)

| | P2 layer | | | | | | | Laminated film | |
| --- | --- | --- | --- | --- | --- | --- | --- | --- | --- |
| | A2 content (Parts by mass) | M2 content (Parts by mass) | B2 concentration $W_B 2$ (% by mass) | C2 concentration $W_{C2}$ (% by mass) | Presence or absence of dispersion phases | Percentage of the number of C2 being present or the like in dispersion phases | Thickness ($10^3$nm) | Laminated ratio | $W_{C1} - W_{C2}$ |
| Example 27 | - | - | - | - | - | - | - | - | - |
| Example 28 | - | - | - | - | - | - | - | - | - |
| Example 29 | - | - | - | - | - | - | - | - | - |

[Table 5]

| | Δb | Tensile elongation at break of film | | Tensile elongation at break of back sheet | |
|---|---|---|---|---|---|
| | | Tensile elongation retention after moist-heat resistance test (%) | Tensile elongation retention after weathering test (%) | Tensile elongation retention after moist-heat resistance test (%) | Tensile elongation retention after weathering test (%) |
| Example 1 | 4 | 50.4 | 15 | 50.4 | 15 |
| Example 2 | 6 | 55.0 | 15 | 55.0 | 15 |
| Example 3 | 4 | 57.2 | 15 | 57.2 | 15 |
| Example 4 | 6 | 71.0 | 15 | 71.0 | 15 |
| Example 5 | 4 | 56.8 | 40 | 56.8 | 40 |
| Example 6 | 6 | 69.2 | 40 | 69.2 | 40 |
| Example 7 | 5 | 59.5 | 21 | 59.5 | 21 |
| Example 8 | 5 | 65.3 | 21 | 65.3 | 21 |
| Example 9 | 5 | 73.5 | 15 | 73.5 | 15 |
| Example 10 | 5 | 70.0 | 30 | 70.0 | 30 |
| Example 11 | 5 | 63.0 | 33 | 63.0 | 33 |
| Example 12 | 5 | 53.6 | 40 | 53.6 | 40 |
| Example 13 | 5 | 65.0 | 40 | 65.0 | 40 |
| Example 14 | 5 | 75.0 | 36 | 75.0 | 36 |
| Example 15 | 5 | 72.0 | 36 | 72.0 | 36 |
| Example 16 | 5 | 70.0 | 36 | 70.0 | 36 |
| Example 17 | 3 | 50.9 | 14 | 50.9 | 14 |
| Example 18 | 5 | 55.3 | 14 | 55.3 | 14 |
| Example 19 | 3 | 58.3 | 14 | 58.3 | 14 |
| Example 20 | 5 | 71.3 | 14 | 71.3 | 14 |

(continued)

|  | Δb | Tensile elongation at break of film | | Tensile elongation at break of back sheet | |
|---|---|---|---|---|---|
|  |  | Tensile elongation retention after moist-heat resistance test (%) | Tensile elongation retention after weathering test (%) | Tensile elongation retention after moist-heat resistance test (%) | Tensile elongation retention after weathering test (%) |
| Example 21 | 3 | 61.9 | 39 | 68.2 | 39 |
| Example 22 | 5 | 72.0 | 39 | 72.0 | 39 |
| Example 23 | 3 | 60.7 | 20 | 60.7 | 20 |
| Example 24 | 4 | 66.6 | 20 | 66.6 | 20 |
| Example 25 | 4 | 77.2 | 14 | 77.2 | 14 |
| Example 26 | 4 | 73.5 | 29 | 73.5 | 29 |
| Example 27 | 4 | 66.2 | 32 | 66.2 | 32 |
| Example 28 | 3 | 64.3 | 39 | 64.3 | 39 |
| Example 29 | 4 | 67.2 | 39 | 67.2 | 39 |

[Table 6]

| | Polyester (A 1) | High melting point resin (B1) | | Extrusion temperature during melt film forming Tc (°C) | tanδ peak temperature (°C) | $(Mw_{A1'}/Mw_{A1})/(Mw_{B1'}/Mw_{B1})$ or | Inorganic particles (C1) | Masterpellet (M1) | | | $\eta_A/\eta_{M1}$ (-) |
| | | Type | Melting point Tm (°C) | | | | | B1 content (Parts by mass) | C1 content (Parts by mass) | C1 concentration (% by mass) | |
|---|---|---|---|---|---|---|---|---|---|---|---|
| Example 30 | PET | PEN | 263 | 280 | 125 | 1.90 | Titanium oxide | 100 | 100 | 50 | 0.49 |
| Example 31 | PET | PEN | 263 | 280 | 125 | 1.90 | Titanium oxide | 100 | 100 | 50 | 0.49 |
| Example 32 | PET | PEN | 263 | 280 | 125 | 1.90 | Barium sulfate | 100 | 100 | 50 | 0.49 |
| Example 33 | PET | PPS | 300 | 315 | 85 | 10 or more | Titanium oxide | 100 | 100 | 50 | 0.45 |
| Example 34 | PET | PPS | 300 | 315 | 85 | 10 or more | Titanium oxide | 100 | 100 | 50 | 0.34 |
| Example 35 | PET | PPS | 300 | 315 | 85 | 10 or more | Titanium oxide | 93 | 7 | 7 | 0.45 |
| Example 36 | PET | PPS | 300 | 315 | 85 | 10 or more | Titanium oxide | 93 | 7 | 7 | 0.34 |
| Example 37 | PET | PPS | 300 | 315 | 85 | 10 or more | Titanium oxide | 61 | 39 | 39 | 0.45 |
| Example 38 | PET | PPS | 300 | 315 | 85 | 10 or more | Titanium oxide | 61 | 39 | 39 | 0.34 |
| Example 39 | PET | PPS | 300 | 315 | 85 | 10 or more | Titanium oxide | 100 | 100 | 50 | 0.42 |
| Example 40 | PET | PPS | 300 | 315 | 85 | 10 or more | Titanium oxide | 100 | 100 | 50 | 0.37 |
| Example 41 | PET | PPS | 300 | 315 | 85 | 10 or more | Titanium oxide | 67 | 33 | 33 | 0.39 |
| Example 42 | PET | PPS | 300 | 315 | 85 | 10 or more | Titanium oxide | 100 | 100 | 50 | 0.39 |

(continued)

| | Polyester (A 1) | High melting point resin (B1) | | Extrusion temperature during melt film forming Tc (°C) | tanδ peak temperature (°C) | $(Mw_{A1'}/Mw_{A1})/(Mw_{B1'}/Mw_{B1})$ or | Inorganic particles (C1) | Masterpellet (M1) | | | $\eta_A/\eta_{M1}$ (-) |
| | | Type | Melting point Tm (°C) | | | | | B1 content (Parts by mass) | C1 content (Parts by mass) | C1 concentration (% by mass) | |
|---|---|---|---|---|---|---|---|---|---|---|---|
| Example 43 | PET | PPS | 300 | 315 | 85 | 10 or more | Titanium oxide | 40 | 60 | 60 | 0.39 |
| Example 44 | PET | PPS | 300 | 315 | 85 | 10 or more | Titanium oxide | 100 | 100 | 50 | 0.42 |
| Example 45 | PET | PPS | 300 | 315 | 85 | 10 or more | Titanium oxide | 100 | 100 | 50 | 0.37 |
| Example 46 | PET | PPS | 300 | 315 | 85 | 10 or more | Titanium oxide | 100 | 100 | 50 | 0.39 |
| Example 47 | PET | PPS | 300 | 315 | 85 | 10 or more | Titanium oxide | 100 | 100 | 50 | 0.39 |
| Example 48 | PET | PPS | 300 | 315 | 85 | 10 or more | Barium sulfate | 100 | 100 | 50 | 0.39 |
| Example 49 | PET | PCHT/I | 283 | 300 | 92 | 1.67 | Titanium oxide | 100 | 100 | 50 | 0.27 |
| Example 50 | PET | PCHT/I | 283 | 310 | 92 | 1.67 | Titanium oxide | 100 | 100 | 50 | 0.27 |
| Example 51 | PET | PCHT/I | 283 | 291 | 92 | 1.67 | Titanium oxide | 100 | 100 | 50 | 0.90 |
| Example 52 | PET | PCHT/I | 283 | 303 | 92 | 1.67 | Titanium oxide | 100 | 100 | 50 | 0.90 |
| Example 53 | PET | PEN | 263 | 280 | 125 | 1.84 | Titanium oxide. | 100 | 100 | 50 | 0.27 |
| Example 54 | PET | PEN | 263 | 290 | 125 | 1.84 | Titanium oxide | 100 | 100 | 50 | 0.27 |
| Example 55 | PET | PEN | 263 | 275 | 125 | 1.84 | Titanium oxide | 100 | 100 | 50 | 0.90 |

(continued)

| | High melting point resin (B1) | | Extrusion temperature during melt film forming Tc (°C) | tanδ peak temperature (°C) | $(Mw_{A1'}/Mw_{A1})/(Mw_{B1'}/Mw_{B1})$ or | Inorganic particles (C1) | Masterpellet (M1) | | | $\eta_A/\eta_{M1}$ (-) |
| Polyester (A1) | Type | Melting point Tm (°C) | | | | | B1 content (Parts by mass) | C1 content (Parts by mass) | C1 concentration (% by mass) | |
|---|---|---|---|---|---|---|---|---|---|---|
| Example 56 | PET | PEN | 263 | 283 | 125 | 1.84 | Titanium oxide | 100 | 100 | 50 | 0.90 |
| Example 57 | PET | PPS | 300 | 327 | 85 | 10 or more | Titanium oxide | 100 | 100 | 50 | 0.27 |
| Example 58 | PET | PPS | 300 | 327 | 85 | 10 or more | Titanium oxide | 100 | 100 | 50 | 0.27 |
| Example 59 | PET | PPS | 300 | 311 | 85 | 10 or more | Titanium oxide | 100 | 100 | 50 | 0.90 |
| Example 60 | PET | PPS | 300 | 320 | 85 | 10 or more | Titanium oxide | 100 | 100 | 50 | 0.90 |

[Table 7]

P1 layer

| | A1 content (Parts by mass) | M1 content (Parts by mass) | B1 concentration $W_{B1}$ (% by mass) | C1 concentration $W_{C1}$ (% by mass) | Presence or absence of dispersion phases | The number of the dispersion phases of more than 30.000nm (30μm) | Longitudinal length of dispersion phases (10³nm) | Percentage of the number of C1 being present or the like in dispersion phases | Thickness (10³nm) |
|---|---|---|---|---|---|---|---|---|---|
| Example 30 | 64 | 36 | 18 | 18 | presence | 0 | 5 | 85 | 7.5 |
| Example 31 | 64 | 36 | 18 | 18 | presence | 0 | 5 | 85 | 7.5 |
| Example 32 | 64 | 36 | 18 | 18 | presence | 0 | 5 | 85 | 7.5 |
| Example 33 | 96 | 4 | 2 | 2 | presence | 0 | 4 | 70 | 50 |
| Example 34 | 96 | 4 | 2 | 2 | presence | 0 | 7 | 95 | 50 |
| Example 35 | 58 | 42 | 40 | 2 | presence | 0 | 4 | 70 | 50 |
| Example 36 | 58 | 42 | 40 | 2 | presence | 0 | 7 | 95 | 50 |
| Example 37 | 35 | 65 | 40 | 25 | presence | 0 | 4 | 70 | 50 |
| Example 38 | 35 | 65 | 40 | 25 | presence | 0 | 7 | 95 | 50 |
| Example 39 | 94 | 6 | 3 | 3 | presence | 0 | 5 | 80 | 50 |
| Example 40 | 94 | 6 | 3 | 3 | presence | 0 | 6 | 90 | 50 |
| Example 41 | 94 | 6 | 4 | 2 | presence | 0 | 6 | 85 | 50 |

(continued)

| | A1 content (Parts by mass) | M1 content (Parts by mass) | P1 layer B1 concentration $W_{B1}$ (% by mass) | C1 concentration $W_{C1}$ (% by mass) | Presence or absence of dispersion phases | The number of the dispersion phases of more than 30,000nm (30μm) | Longitudinal length of dispersion phases ($10^3$nm) | Percentage of the number of C1 being present or the like in dispersion phases | Thickness ($10^3$nm) |
|---|---|---|---|---|---|---|---|---|---|
| Example 42 | 92 | 8 | 4 | 4 | presence | 0 | 6 | 85 | 50. |
| Example 43 | 90 | 10 | 4 | 6 | presence | 0 | 6 | 85 | 50 |
| Example 44 | 50 | 50 | 25 | 25 | presence | 0 | 5 | 80 | 50 |
| Example 45 | 50 | 50 | 25 | 25 | presence | 0 | 6 | 90 | 50 |
| Example 46 | 64 | 36 | 18 | 18 | presence | 0 | 6 | 85 | 7.5 |
| Example 47 | 64 | 36 | 18 | 18 | presence | 0 | 6 | 85 | 7.5 |
| Example 48 | 64 | 36 | 18 | 18 | presence | 0 | 6 | 85 | 7.5 |
| Example 49 | 64 | 36 | 18 | 18 | presence | 0 | 9 | 85 | 50 |
| Example 50 | 64 | 36 | 18 | 18 | presence | 0 | 7 | 85 | 50 |
| Example 51 | 64 | 36 | 18 | 18 | presence | 1 | 3 | 85 | 50 |
| Example 52 | 64 | 36 | 18 | 18 | presence | 0 | 2 | 85 | 50 |
| Example 53 | 64 | 36 | 18 | 18 | presence | 0 | 9 | 85 | 50 |

(continued)

| | P1 layer | | | | | | | | |
|---|---|---|---|---|---|---|---|---|---|
| | A1 content (Parts by mass) | M1 content (Parts by mass) | B1 concentration $W_{B1}$ (% by mass) | C1 concentration $W_{C1}$ (% by mass) | Presence or absence of despersion phases | The number of the dispersion phases of more than 30.000nm (30μm) | Longitudinal length of dispersion phases ($10^3$nm) | Percentage of the number of C1 being present or the like in dispersion phases | Thickness ($10^3$nm) |
| Example 54 | 64 | 36 | 18 | 18 | presence | 0 | 7 | 85 | 50 |
| Example 55 | 64 | 36 | 18 | 18 | presence | 0 | 3 | 85 | 50 |
| Example 56 | 64 | 36 | 18 | 18 | presence | 0 | 2 | 85 | 50 |
| Example 57 | 64 | 36 | 18 | 18 | presence | 0 | 9 | 85 | 50 |
| Example 58 | 64 | 36 | 18 | 18 | presence | 0 | 7 | 85 | 50 |
| Example 59 | 64 | 36 | 18 | 18 | presence | 0 | 3 | 85 | 50 |
| Example 60 | 64 | 36 | 18 | 18 | presence | 0 | 2 | 85 | 50 |

[Table 8]

| | Polyester (A2) | High melting point resin (B2) | | Inorganic particles (C2) | Masterpellet (M2) | | | $\eta_A/\eta_{M2}$ (-) |
| | | Type | Melting point Tm (°C) | | B2 content (Parts by mass) | C2 content (Parts by mass) | C2 concentration (% by mass) | |
|---|---|---|---|---|---|---|---|---|
| Example 30 | PET | PEN | 263 | Titanium oxide | 100 | 100 | 50 | 0.49 |
| Example 31 | PET | PEN | 263 | Titanium oxide | 100 | 100 | 50 | 0.49 |
| Example 32 | PET | PEN | 263 | Barium sulfate | 100 | 100 | 50 | 0.49 |
| Example 33 | - | - | - | - | - | - | - | - |
| Example 34 | - | - | - | - | - | - | - | - |
| Example 35 | - | - | - | - | - | - | - | - |
| Example 36 | - | - | - | - | - | - | - | - |
| Example 37 | - | - | - | - | - | - | - | - |
| Example 38 | - | - | - | - | - | - | - | - |
| Example 39 | - | - | - | - | - | - | - | - |
| Example 40 | - | - | - | - | - | - | - | - |
| Example 41 | - | - | - | - | - | - | - | - |
| Example 42 | - | - | - | - | - | - | - | - |
| Example 43 | - | - | - | - | - | - | - | - |
| Example 44 | - | - | - | - | - | - | - | - |
| Example 45 | - | - | - | - | - | - | - | - |
| Example 46 | PET | PPS | 300 | Titanium oxide | 100 | 100 | 50 | 0.39 |
| Example 47 | PET | PPS | 300 | Titanium oxide | 100 | 100 | 50 | 0.39 |
| Example 48 | PET | PPS | 300 | Barium sulfate | 100 | 100 | 50 | 0.39 |
| Example 49 | - | - | - | - | - | - | - | - |

(continued)

| | Polyester (A2) | High melting point resin (B2) | | Inorganic particles (C2) | Masterpellet (M2) | | | $\eta_A/\eta_{M2}$ (-) |
| | | Type | Melting point Tm (°C) | | B2 content (Parts by mass) | C2 content (Parts by mass) | C2 concentration (% by mass) | |
|---|---|---|---|---|---|---|---|---|
| Example 50 | - | - | - | - | - | - | - | - |
| Example 51 | - | - | - | - | - | - | - | - |
| Example 52 | - | - | - | - | - | - | - | - |
| Example 53 | - | - | - | - | - | - | - | - |
| Example 54 | - | - | - | - | - | - | - | - |
| Example 55 | - | - | - | - | - | - | - | - |
| Example 56 | - | - | - | - | - | - | - | - |
| Example 57 | - | - | - | - | - | - | - | - |
| Example 58 | - | - | - | - | - | - | - | - |
| Example 59 | - | - | - | - | - | - | - | - |
| Example 60 | - | - | - | - | - | - | - | - |

[Table 9]

| | P2 layer | | | | | | Laminated film | | |
| --- | --- | --- | --- | --- | --- | --- | --- | --- | --- |
| | A2 content (Parts by mass) | M2 content (Parts by mass) | B2 concentration $W_{B2}$ (% by mass) | C2 concentration $W_{C2}$ (% by mass) | Presence or absence of dispersion phases | Percentage of the number of C2 being present or the like in dispersion phases | Thickness ($10^3$ nm) | Laminated ratio | $W_{C1}-W_{C2}$ |
| Example 30 | 99 | 1 | 0.5 | 0.5 | presence | 85 | 42.5 | 1 : 6 | 17.5 |
| Example 31 | 97 | 3 | 1.5 | 1.5 | presence | 85 | 42.5 | 1 : 6 | 16.5 |
| Example 32 | 97 | 3 | 1.5 | 1.5 | presence | 85 | 42.5 | 1 : 6 | 16.5 |
| Example 33 | - | - | - | - | - | - | - | - | - |
| Example 34 | - | - | - | - | - | - | - | - | - |
| Example 35 | - | - | - | - | - | - | - | - | - |
| Example 36 | - | - | - | - | - | - | - | - | - |
| Example 37 | - | - | - | - | - | - | - | - | - |
| Example 38 | - | - | - | - | - | - | - | - | - |
| Example 39 | - | - | - | - | - | - | - | - | - |
| Example 40 | - | - | - | - | - | - | - | - | - |
| Example 41 | - | - | - | - | - | - | - | - | - |
| Example 42 | - | - | - | - | - | - | - | - | - |

| | P2 layer | | | | | | | Laminated film | |
|---|---|---|---|---|---|---|---|---|---|
| | A2 content (Parts by mass) | M2 content (Parts by mass) | B2 concentration $W_{B2}$ (% by mass) | C2 concentration $W_{C2}$ (% by mass) | Presence or absence of dispersion phases | Percentage of the number of C2 being present or the like in dispersion phases | Thickness ($10^3$nm) | Laminated ratio | $W_{C1}$-$W_{C2}$ |
| Example 43 | - | - | - | - | - | - | - | - | - |
| Example 44 | - | - | - | - | - | - | - | - | - |
| Example 45 | - | - | - | - | - | - | - | - | - |
| Example 46 | 99 | 1 | 0.5 | 0.5 | presence | 85 | 42.5 | 1 : 6 | 17.5 |
| Example 47 | 97 | 3 | 1.5 | 1.5 | presence | 85 | 42.5 | 1 : 6 | 16.5 |
| Example 48 | 97 | 3 | 1.5 | 1.5 | presence | 85 | 42.5 | 1 : 6 | 16.5 |
| Example 49 | - | - | - | - | - | - | - | - | |
| Example 50 | - | - | - | - | - | - | - | - | - |
| Example 51 | - | - | - | - | - | - | - | - | - |
| Example 52 | - | - | - | - | - | - | - | - | - |
| Example 53 | - | - | - | - | - | - | - | - | - |
| Example 54 | - | - | - | - | - | - | - | - | - |
| Example 55 | - | - | - | - | - | - | - | - | - |

(continued)

| | P2 layer | | | | | | | Laminated film | | |
|---|---|---|---|---|---|---|---|---|---|---|
| | A2 content (Parts by mass) | M2 content (Parts by mass) | B2 concentration $W_{B2}$ (% by mass) | C2 concentration $W_{C2}$ (% by mass) | Presence or absence of dispersion phases | Percentage of the number of C2 being present or the like in dispersion phases | Thickness ($10^3$nm) | Laminated ratio | $W_{C1}$-$W_{C2}$ |
| Example 56 | - | - | - | - | - | - | - | - | - |
| Example 57 | - | - | - | - | - | - | - | - | - |
| Example 58 | - | - | - | - | - | - | - | - | - |
| Example 59 | - | - | - | - | - | - | - | - | - |
| Example 60 | - | - | - | - | - | - | - | - | - |

[Table 10]

| | Δb | Tensile elongation at break of film | | Tensile elongation at break of back sheet | |
|---|---|---|---|---|---|
| | | Tensile elongation retention after moist-heat resistance test (%) | Tensile elongation retention after weathering test (%) | Tensile elongation retention after moist-heat resistance test (%) | Tensile elongation retention after weathering test (%) |
| Example 30 | 4 | 81.2 | 35 | 81.2 | 35 |
| Example 31 | 4 | 77.3 | 35 | 77.3 | 35 |
| Example 32 | 4 | 75.3 | 35 | 75.3 | 35 |
| Example 33 | 3 | 51.4 | 10 | 51.4 | 10 |
| Example 34 | 6 | 55.9 | 10 | 55.9 | 10 |
| Example 35 | 3 | 62.2 | 10 | 62.2 | 10 |
| Example 36 | 6 | 72.8 | 10 | 72.8 | 10 |
| Example 37 | 3 | 63.2 | 35 | 63.2 | 35 |
| Example38 | 6 | 72.2 | 35 | 72.2 | 35 |
| Example 39 | 4 | 61.3 | 16 | 61.3 | 16 |
| Example 40 | 5 | 67.3 | 16 | 67.3 | 16 |
| Example 41 | 5 | 77.9 | 10 | 77.9 | 10 |
| Example 42 | 5 | 74.2 | 25 | 74.2 | 25 |
| Example 43 | 5 | 66.8 | 28 | 66.8 | 28 |
| Example 44 | 4 | 65.9 | 35 | 65.9 | 35 |
| Example 45 | 5 | 68.2 | 35 | 68.2 | 35 |
| Example 46 | 5 | 82.9 | 31 | 82.9 | 31 |
| Example 47 | 5 | 79.2 | 31 | 79.2 | 31 |
| Example 48 | 5 | 80.6 | 31 | 80.6 | 31 |
| Example 49 | 9 | 63.0 | 35 | 63.0 | 35 |
| Example 50 | 7 | 61.0 | 35 | 61.0 | 35 |
| Example 51 | 2 | 67.2 | 35 | 67.2 | 35 |
| Example 52 | 1 | 61.1 | 35 | 61.1 | 35 |
| Example 53 | 9 | 67.2 | 32 | 67.2 | 32 |
| Example 54 | 8 | 65.8 | 32 | 65.8 | 32 |
| Example 55 | 3 | 71.0 | 32 | 71.0 | 32 |
| Example 56 | 2 | 65.3 | 32 | 65.3 | 32 |
| Example 57 | 10 | 73.0 | 30 | 73.0 | 30 |
| Example 58 | 8 | 71.5 | 30 | 71.5 | 30 |
| Example 59 | 3 | 78.3 | 30 | 78.3 | 30 |
| Example 60 | 2 | 72.2 | 30 | 72.2 | 30 |

[Table 11]

| | Polyester (A 1) | High melting point resin (B1) | | Extrusion temperature during melt film forming Tc(°C) | tan$\delta$ peak temperature (°C) | $(Mw_{A 1'}/Mw_{A 1})/(Mw_{B 1'}/Mw_{B 1})$ | Inorganic particles (C1) | Masterpellet (M1) | | | $\eta_A/\eta_{M1}$ (-) |
| | | Type | Melting point Tm (°C) | | | | | B1 content (Parts by mass) | C1 content (Parts by mass) | C1 concentration (% by mass) | |
|---|---|---|---|---|---|---|---|---|---|---|---|
| Example 61 | PET | PCHT/I | 283 | 290 | 92 | 1.84 | Titanium oxide | 100 | 100 | 50 | 0.90 |
| Example 62 | PET | PCHT/I | 283 | 295 | 92 | 1.84 | Titanium oxide | 100 | 100 | 50 | 0.23 |
| Example 63 | PET | PCHT/I | 283 | 293 | 92 | 1.84 | Titanium oxide | 100 | 100 | 50 | 0.27 |
| Example 64 | PET | PEN | 263 | 270 | 125 | 1.90 | Titanium oxide | 100 | 100 | 50 | 0.90 |
| Example 65 | PET | PEN | 263 | 275 | 125 | 1.90 | Titanium oxide | 100 | 100 | 50 | 0.23 |
| Example 66 | PET | PEN | 263 | 273 | 125 | 1.90 | Titanium oxide | 100 | 100 | 50 | 0.27 |
| Example 67 | PET | PPS | 300 | 307 | 85 | 10 or more | Titanium oxide | 100 | 100 | 50 | 0.90 |
| Example 68 | PET | PPS | 300 | 312 | 85 | 10 or more | Titanium oxide | 100 | 100 | 50 | 0.23 |
| Example 69 | PET | PPS | 300 | 310 | 85 | 10 or more | Titanium oxide | 100 | 100 | 50 | 0.27 |
| Comparative Example 70 | PEN | PCHT/I | 283 | 300 | 92 | 1.51 | Titanium oxide | 100 | 100 | 50 | 0.38 |
| Comparative Example 71 | PEN | PPS | 300 | 315 | 85 | 10 or more | Titanium oxide | 100 | 100 | 50 | 0.38 |
| Example 72 | PET | PCHT/I | 283 | 303 | 92 | 1.84 | Titanium oxide | 100 | 100 | 50 | 0.95 |

| | Polyester (A 1) | High melting point resin (B1) | | Extrusion temperature during melt film forming Tc(°C) | tanδ peak temperature (°C) | $(Mw_{A1'}/Mw_{A1})/(Mw_{B1'}/Mw_{B1})$ | Inorganic particles (C1) | Masterpellet (M1) | | | $\eta_A/\eta_{M1}$ (-) |
| | | Type | Melting point Tm (°C) | | | | | B1 content (Parts by mass) | C1 content (Parts by mass) | C1 concentration (% by mass) | |
|---|---|---|---|---|---|---|---|---|---|---|---|
| Example 73 | PET | PCHT | 290 | 310 | 95 | 2.01 | Titanium oxide | 100 | 100 | 50 | 0.95 |
| Example 74 | PET | PCHT | 290 | 307 | 95 | 2.01 | Titanium oxide | 100 | 100 | 50 | 0.45 |
| Comparative example 1 | PET | PET/N | 250 | 300 | 82 | 1.10 | Titanium oxide | 43 | 57 | 57 | 0.70 |
| Comparative example 2 | PET | PET/N | 250 | 300 | 82 | 1.10 | Titanium oxide | 43 | 57 | 57 | 0.58 |
| Comparative example 3 | PET | PET/N | 250 | 300 | 82 | 1.10 | Titanium oxide | 100 | 100 | 50 | 0.92 |
| Comparative example 4 | PET | PET/N | 250 | 300 | 82 | 1.10 | Titanium oxide | 93 | 7 | 7 | 0.92 |
| Comparative example 5 | PET | PET/N | 250 | 300 | 82 | 1.10 | Titanium oxide | 97.7 | 2.3 | 2.3 | 0.70 |
| Comparative example 6 | PET | PET/N | 250 | 300 | 82 | 1.10 | Titanium oxide | 97.7 | 2.3 | 2.3 | 0.61 |
| Comparative example 7 | PET | PEDPC | 330 | 350 | 130 | 2.20 | Titanium oxide | 43 | 57 | 57 | 0.70 |
| Comparative example 8 | PET | PEDPC | 330 | 350 | 130 | 2.20 | Titanium oxide | 43 | 57 | 57 | 0.58 |
| Comparative example 9 | PET | PEDPC | 330 | 350 | 130 | 2.20 | Titanium oxide | 100 | 100 | 50 | 0.92 |
| Comparative example 10 | PET | PEDPC | 330 | 350 | 130 | 2.20 | Titanium oxide | 93 | 7 | 7 | 0.92 |

| | Polyester (A 1) | High melting point resin (B1) | | Extrusion temperature during melt film forming Tc(°C) | tan$\delta$ peak temperature (°C) | $(Mw_{A\,1'}/Mw_{A\,1})/(Mw_{B\,1'}/Mw_{B\,1})$ | Inorganic particles (C1) | Masterpellet (M1) | | | $\eta_A/\eta_{M1}$ (-) |
| | | Type | Melting pointTm (°C) | | | | | B1content (Parts by mass) | C1 content (Parts by mass) | C1 concentration (% by mass) | |
|---|---|---|---|---|---|---|---|---|---|---|---|
| Comparative example 11 | PET | PEDPC | 330 | 350 | 130 | 2.20 | Titanium oxide | 97.7 | 2.3 | 2.3 | 0.70 |
| Comparative example 12 | PET | PEDPC | 330 | 350 | 130 | 2.20 | Titanium oxide | 97.7 | 2.3 | 2.3 | 0.61 |
| Comparative example 13 | PET | PCHT/I | 283 | 300 | 92 | 1.84 | Titanium oxide | 43 | 57 | 57 | 0.42 |

[Table 12]

P1 layer

| | A1 content (Parts by mass) | M1 content (Parts by mass) | B1 concentration $W_{B1}$ (% by mass) | C1 concentration $W_{C1}$ (% by mass) | Presence or absence of dispersion phases | The number of the dispersion phases of more than 30,000nm (30μm) | Longitudinal length of dispersion phases | Percentage of the number of C1 being present or the like in dispersion phases | Thickness ($10^3$nm) |
|---|---|---|---|---|---|---|---|---|---|
| Example 61 | 64 | 36 | 18 | 18 | presence | 1 | 12 | 80 | 50 |
| Example 62 | 64 | 36 | 18 | 18 | presence | 1 | 13 | 80 | 50 |
| Example 63 | 64 | 36 | 18 | 18 | presence | 2 | 15 | 80 | 50 |
| Example 64 | 64 | 36 | 18 | 18 | presence | 1 | 12 | 80 | 50 |
| Example 65 | 64 | 36 | 18 | 18 | presence | 1 | 13 | 80 | 50 |
| Example 66 | 64 | 36 | 18 | 18 | presence | 2 | 15 | 80 | 50 |
| Example 67 | 64 | 36 | 18 | 18 | presence | 1 | 12 | 80 | 50 |
| Example 68 | 64 | 36 | 18 | 18 | presence | 1 | 13 | 80 | 50 |
| Example 69 | 64 | 36 | 18 | 18 | presence | 2 | 15 | 80 | 50 |
| Comparative Example 70 | 64 | 36 | 18 | 18 | presence | 0 | 8 | 80 | 50 |
| Comparative Example 71 | 64 | 36 | 18 | 18 | presence | 0 | 8 | 80 | 50 |
| Example 72 | 64 | 36 | 18 | 18 | presence | 0 | 1 | 80 | 50 |
| Example 73 | 64 | 36 | 18 | 18 | presence | 0 | 1 | 80 | 50 |
| Example 74 | 64 | 36 | 18 | 18 | presence | 0 | 5 | 80 | 50 |
| Comparative example 1 | 96.5 | 3.5 | 1.5 | 2 | presence | 0 | 3 | 70 | 50 |
| Comparative example 2 | 96.5 | 3.5 | 1.5 | 2 | presence | 0 | 5 | 95 | 50 |
| Comparative example 3 | 96 | 4 | 2 | 2 | presence | 0 | 2 | 65 | 50 |
| Comparative example 4 | 58 | 42 | 40 | 2 | presence | 0 | 2 | 65 | 50 |

(continued)

| | P1 layer | | | | | | | | |
|---|---|---|---|---|---|---|---|---|---|
| | A1 content (Parts by mass) | M1 content (Parts by mass) | B1 concentration $W_{B1}$ (% by mass) | C1 concentration $W_{C1}$ (% by mass) | Presence or absence of despersion phases | The number of the dispersion phases of more than 30,000nm (30$\mu$m) | Longitudinal length of dispersion phases | Percentage of the number of C1 being present or the like in dispersion phases | Thickness ($10^3$nm) |
| Comparative example 5 | 56 | 44 | 42 | 2 | presence | 0 | 3 | 70 | 50 |
| Comparative example 6 | 56 | 44 | 42 | 2 | presence | 0 | 4 | 90 | 50 |
| Comparative example 7 | 96.5 | 3.5 | 1.5 | 2 | presence | 0 | 3 | 70 | 50 |
| Comparative example 8 | 96.5 | 3.5 | 1.5 | 2 | presence | 0 | 5 | 95 | 50 |
| Comparative example 9 | 96 | 4 | 2 | 2 | presence | 0 | 2 | 65 | 50 |
| Comparative example 10 | 58 | 42 | 40 | 2 | presence | 0 | 2 | 65 | 50 |
| Comparative example 11 | 56 | 44 | 42 | 2 | presence | 0 | 3 | 70 | 50 |
| Comparative example 12 | 56 | 44 | 42 | 2 | presence | 0 | 5 | 90 | 50 |
| Comparative example 13 | 96.5 | 3.5 | 1.5 | 2 | Presence | 0 | 6 | 70 | 50 |

[Table 13]

| | Polyester (A2) | High melting point resin (B2) | | Inorganic particles (C2) | Masterpellet (M2) | | | $\eta_A/\eta_{M2}$ (-) |
| | | Type | Melting point Tm (°C) | | B2 content (Parts by mass) | C2 content (Parts by mass) | C2 concentration (% by mass) | |
|---|---|---|---|---|---|---|---|---|
| Example 61 | - | - | - | - | - | - | - | - |
| Example 62 | - | - | - | - | - | - | - | - |
| Example 63 | - | - | - | - | - | - | - | - |
| Example 64 | - | - | - | - | - | - | - | - |
| Example 65 | - | - | - | - | - | - | - | - |
| Example 66 | - | - | - | - | - | - | - | - |
| Example 67 | - | - | - | - | - | - | - | - |
| Example 68 | - | - | - | - | - | - | - | - |
| Example 69 | - | - | - | - | - | - | - | - |
| Comparative Example 70 | - | - | - | - | - | - | - | - |
| Comparative Example 71 | - | - | - | - | - | - | - | - |
| Example 72 | - | - | - | - | - | - | - | - |
| Example 73 | - | - | - | - | - | - | - | - |
| Example 74 | - | - | - | - | - | - | - | - |
| Comparative example 1 | - | - | - | - | - | - | - | - |
| Comparative example 2 | - | - | - | - | - | - | - | - |
| Comparative example 3 | - | - | - | - | - | - | - | - |
| Comparative example 4 | - | - | - | - | - | - | - | - |
| Comparative example 5 | - | - | - | - | - | - | - | - |
| Comparative example 6 | - | - | - | - | - | - | - | - |
| Comparative example 7 | - | - | - | - | - | - | - | - |
| Comparative example 8 | - | - | - | - | - | - | - | - |
| Comparative example 9 | - | - | - | - | - | - | - | - |
| Comparative example 10 | - | - | - | - | - | - | - | - |
| Comparative example 11 | - | - | - | - | - | - | - | - |

(continued)

| | Polyester (A2) | High melting point resin (B2) | | Inorganic particles (C2) | Masterpellet (M2) | | | $\eta_A/\eta_{M2}$ (-) |
| | | Type | Melting point Tm (°C) | | B2 content (Parts by mass) | C2 content (Parts by mass) | C2 concentration (% by mass) | |
|---|---|---|---|---|---|---|---|---|
| Comparative example 12 | - | - | - | - | - | - | - | - |
| Comparative example 13 | - | - | - | - | - | - | - | - |

[Table 14]

| | P2 layer | | | | | | | Laminated film | | |
|---|---|---|---|---|---|---|---|---|---|---|
| | A2 content (Parts by mass) | M2 content (Parts by mass) | B2 concentration $W_{B2}$ (% by mass) | C2 concentration $W_{C2}$ (% by mass) $W_{C2}$ by | Presence or absence of dispersion phases | Percentage of the number of C2 being present or the like in dispersion phases | Thickness ($10^3$nm) | Laminated ratio | $W_{C1}-W_{C2}$ | |
| Example 61 | - | - | - | - | - | - | - | - | - | |
| Example 62 | - | - | - | - | - | - | - | - | - | |
| Example 63 | - | - | - | - | - | - | - | - | - | |
| Example 64 | - | - | - | - | - | - | - | - | - | |
| Example 65 | - | - | - | - | - | - | - | - | - | |
| Example 66 | - | - | - | - | - | - | - | - | - | |
| Example 67 | - | - | - | - | - | - | - | - | - | |
| Example 68 | - | - | - | - | - | - | - | - | - | |
| Example 69 | - | - | - | - | - | - | - | - | - | |
| Comparative Example 70 | - | - | - | - | - | - | - | - | - | |
| Comparative Example 71 | - | - | - | - | - | - | - | - | - | |
| Example 72 | - | - | - | - | - | - | - | - | - | |
| Example 73 | - | - | - | - | - | - | - | - | - | |
| Example 74 | - | - | - | - | - | - | - | - | - | |
| Comparative example 1 | - | - | - | - | - | - | - | - | - | |
| Comparative example 2 | - | - | - | - | - | - | - | - | - | |
| Comparative example 3 | - | - | - | - | - | - | - | - | - | |
| Comparative example 4 | - | - | - | - | - | - | - | - | - | |

(continued)

| | P2 layer | | | | | | Laminated film | | | |
|---|---|---|---|---|---|---|---|---|---|---|
| | A2 content (Parts by mass) | M2 content (Parts by mass) | B2 concentration $W_{B2}$ (% by mass) | C2 concentration $W_{C2}$ (% by mass) $W_{C2}$ by | Presence or absence of dispersion phases | Percentage of the number of C2 being present or the like in dispersion phases | Thickness ($10^3$nm) | Laminated ratio | $W_{C1}$-$W_{C2}$ |
| Comparative example 5 | - | - | - | - | - | - | - | - | - |
| Comparative example 6 | - | - | - | - | - | - | - | - | - |
| Comparative example 7 | - | - | - | - | - | - | - | - | - |
| Comparative example 8 | - | - | - | - | - | - | - | - | - |
| Comparative example 9 | - | - | - | - | - | - | - | - | - |
| Comparative example 10 | - | - | - | - | - | - | - | - | - |
| Comparative example 11 | - | - | - | - | - | - | - | - | - |
| Comparative example 12 | - | - | - | - | - | - | - | - | - |
| Comparative example 13 | - | - | - | - | - | - | - | - | - |

[Table 15]

| | Δb | Tensile elongation at break of film | | Tensile elongation at break of back sheet | |
|---|---|---|---|---|---|
| | | Tensile elongation retention after moist-heat resistance test (%) | Tensile elongation retention after weathering test (%) | Tensile elongation retention after moist-heat resistance test (%) | Tensile elongation retention after weathering test (%) |
| Example 61 | 9 | 67.0 | 30 | 67.0 | 32 |
| Example 62 | 9 | 65.4 | 33 | 65.4 | 35 |
| Example 63 | 10 | 64.3 | 28 | 64.3 | 30 |
| Example 64 | 9 | 68.2 | 28 | 67.0 | 32 |
| Example 65 | 9 | 65.6 | 31 | 65.4 | 35 |
| Example 66 | 10 | 65.1 | 26 | 64.3 | 30 |
| Example 67 | 9 | 77.0 | 25 | 77.0 | 25 |
| Example 68 | 9 | 75.4 | 28 | 75.4 | 28 |
| Example 69 | 10 | 74.3 | 23 | 74.3 | 23 |
| Comparative Example 70 | 10 | 80.2 | 32 | 80.2 | 32 |
| Comparative Example 71 | 10 | 85.2 | 32 | 85.2 | 32 |
| Example 72 | 1 | 62.5 | 42 | 62.5 | 42 |
| Example 73 | 1 | 67.1 | 40 | 67.1 | 40 |
| Example 74 | 2 | 72.5 | 40 | 72.5 | 40 |
| Comparative example 1 | 3 | 45.3 | 15 | 45.3 | 15 |
| Comparative example 2 | 4 | 46.5 | 15 | 46.5 | 15 |
| Comparative example 3 | 1 | 47.2 | 15 | 47.2 | 15 |
| Comparative example 4 | 1 | 47.3 | 15 | 47.3 | 15 |
| Comparative example 5 | 2 | - | - | - | - |
| Comparative example 6 | 3 | - | - | - | - |
| Comparative example 7 | 3 | 22.1 | 5 | 22.1 | 5 |
| Comparative example 8 | 4 | 24.3 | 6 | 24.3 | 6 |
| Comparative example 9 | 1 | 25.3 | 7 | 25.3 | 7 |
| Comparative example 10 | 1 | 26.3 | 8 | 26.3 - | 8 |
| Comparative example 11 | 2 | - | - | - | - |

(continued)

| | Δb | Tensile elongation at break of film | | Tensile elongation at break of back sheet | |
| --- | --- | --- | --- | --- | --- |
| | | Tensile elongation retention after moist-heat resistance test (%) | Tensile elongation retention after weathering test (%) | Tensile elongation retention after moist-heat resistance test (%) | Tensile elongation retention after weathering test (%) |
| Comparative example 12 | 4 | - | - | - | - |
| Comparative example 13 | 5 | 47.3 | 15 | 45.2 | 15 |

[Table 16]

| | Polyester (A1) | High melting point resin (B1) | | Extrusion temperature during melt film forming Tc (°C) | tanδpeak temperature (°C) | $(Mw_{A1'}/Mw_{A1})/(Mw_{B1'}/Mw_{B1})$ | Inorganic particles (C1) | Masterpellet (M1) | | | $\eta_{A}/\eta_{M1}$ (-) |
| | | Type | Melting point Tm (°C) | | | | | B1 content (Parts by mass) | C1 content (Parts by mass) | C1 concentration (% by mass) | |
|---|---|---|---|---|---|---|---|---|---|---|---|
| Comparative example 14 | PET | PCHT/I | 283 | 300 | 92 | 1.84 | Titanium oxide | 97.7 | 2.3 | 2.3 | 0.42 |
| Comparative example 15 | PET | PEN | 263 | 280 | 125 | 1.90 | Titanium oxide | 43 | 57 | 57 | 0.55 |
| Comparative example 16 | PET | PEN | 263 | 280 | 125 | 1.90 | Titanium oxide | 97.7 | 2.3 | 2.3 | 0.55 |
| Comparative example 17 | PET | PPS | 300 | 315 | 85 | 10 or more | Titanium oxide | 43 | 57 | 57 | 0.45 |
| Comparative example 18 | PET | PPS | 300 | 315 | 85 | 10 or more | Titanium oxide | 97.7 | 2.3 | 2.3 | 0.45 |
| Comparative example 19 | PET | PCHT/I | 283 | 300 | 92 | 1.84 | Titanium oxide | 100 | 100 | 50 | 1.10 |
| Comparative example 20 | PET | PEN | 283 | 300 | 125 | 1.90 | Titanium oxide | 100 | 100 | 50 | 1.10 |
| Comparative example 21 | PET | PPS | 283 | 300 | 85 | 10 or more | Titanium oxide | 100 | 100 | 50 | 1.10 |
| Comparative example 22 | PET | PCHT/I | 283 | 294 | 92 | 1.84 | Titanium oxide | 100 | 100 | 50 | 0.27 |
| Comparative example 23 | PET | PEN | 263 | 275 | 125 | 1.90 | Titanium oxide | 100 | 100 | 50 | 0.27 |
| Comparative example 24 | PET | PPS | 300 | 310 | 85 | 10 or more | Titanium oxide | 100 | 100 | 50 | 0.27 |
| Comparative example 25 | PET | PCHT/I | 283 | 300 | 92 | 1.84 | Titanium oxide | 100 | 100 | 50 | 0.18 |

| | Polyester (A 1) | High melting point resin (B1) | | Extrusion temperature during melt film forming Tc (°C) | $\tan\delta$ peak temperature (°C) | $(Mw_{A1}/Mw_{A1})/(Mw_{B1}/Mw_{B1})$ | Inorganic particles (C1) | Masterpellet (M1) | | | $\eta_A/\eta_{M1}$ (-) |
| | | Type | Melting point Tm (°C) | | | | | B1 content (Parts by mass) | C1 content (Parts by mass) | C1 concentration (% by mass) | |
|---|---|---|---|---|---|---|---|---|---|---|---|
| Comparative example 26 | PET | PEN | 263 | 280 | 125 | 1.90 | Titanium oxide | 100 | 100 | 50 | 0.18 |
| Comparative example 27 | PET | PPS | 300 | 315 | 85 | 10 or more | Titanium oxide | 100 | 100 | 50 | 0.18 |
| Comparative example 28 | PET | PCHT/G | 265 | 290 | 82 | 1.30 | Titanium oxide | 100 | 100 | 50 | 0.36 |

[Table 17]

| | P1 layer | | | | | | | | |
|---|---|---|---|---|---|---|---|---|---|
| | A1 content (Parts by mass) | M1 content (Parts by mass) | B1 concentration $W_{B1}$ (% by mass) | C1 concentration $W_{C1}$ (% by mass) | Presence or absence of despersion phases | The number of the dispersion phases of more than 30,000nm (30μm) | Longitudinal length of dispersion phases | Percentage of the number of C1 being present or the like in dispersion phases | Thickness ($10^3$nm) |
| Comparative example 14 | 56 | 44 | 42 | 2 | presence | 0 | 6 | 70 | 50 |
| Comparative example 15 | 96.5 | 3.5 | 1.5 | 2 | presence | 0 | 5 | 70 | 50 |
| Comparative example 16 | 56 | 44 | 42 | 2 | presence | 0 | 5 | 70 | 50 |
| Comparative example 17 | 96.5 | 3.5 | 1.5 | 2 | presence | 0 | 6 | 70 | 50 |
| Comparative example 18 | 56 | 44 | 42 | 2 | presence | 0 | 6 | 70 | 50 |
| Comparative example 19 | 96 | 4 | 2 | 2 | なし | 0 | - | - | 50 |
| Comparative example 20 | 96 | 4 | 2 | 2 | なし | 0 | - | - | 50 |
| Comparative example 21 | 96 | 4 | 2 | 2 | なし | 0 | - | - | 50 |
| Comparative example 22 | 64 | 36 | 18 | 18 | presence | 3 | 15 | 85 | 50 |
| Comparative example 23 | 64 | 36 | 18 | 18 | presence | 3 | 15 | 85 | 50 |
| Comparative example 24 | 64 | 36 | 18 | 18 | presence | 3 | 15 | 85 | 50 |
| Comparative example 25 | 64 | 36 | 18 | 18 | presence | 3 | 12 | 85 | 50 |
| Comparative example 26 | 64 | 36 | 18 | 18 | presence | 3 | 12 | 85 | 50 |

(continued)

| | P1 layer | | | | | | | | |
|---|---|---|---|---|---|---|---|---|---|
| | A1 content (Parts by mass) | M1 content (Parts by mass) | B1 concentration $W_{B1}$ (% by mass) | C1 concentration $W_{C1}$ (% by mass) | Presence or absence of despersion phases | The number of the dispersion phases of more than 30,000nm (30$\mu$m) | Longitudinal length of dispersion phases | Percentage of the number of C1 being present or the like in dispersion phases | Thickness ($10^3$nm) |
| Comparative example 27 | 64 | 36 | 18 | 18 | presence | 3 | 12 | 85 | 50 |
| Comparative example 28 | 64 | 36 | 18 | 18 | presence | 3 | 8 | 85 | 50 |

[Table 18]

| | Polyester (A2) | High melting point resin (B2) | | Inorganic particles (C2) | Masterpetlet (M2) | | | $\eta_A/\eta_{M2}$ (-) |
| --- | --- | --- | --- | --- | --- | --- | --- | --- |
| | | Type | Melting point Tm (°C) | | B2 or D2 content (Parts by mass) | C2 content (Parts by mass) | C2 concentration (% by mass) | |
| Comparative example 14 | - | - | - | - | - | - | - | - |
| Comparative example 15 | - | - | - | - | - | - | - | - |
| Comparative example 16 | - | - | - | - | - | - | - | - |
| Comparative example 17 | - | - | - | - | - | - | - | - |
| Comparative example 18 | - | - | - | - | - | - | - | - |
| Comparative example 19 | - | - | - | - | - | - | - | - |
| Comparative example 20 | - | - | - | - | - | - | - | - |
| Comparative example 21 | - | - | - | - | - | - | - | - |
| Comparative example 22 | - | - | - | - | - | - | - | - |
| Comparative example 23 | - | - | - | - | - | - | - | - |
| Comparative example 24 | - | - | - | - | - | - | - | - |
| Comparative example 25 | - | - | - | - | - | - | - | - |
| Comparative example 26 | - | - | - | - | - | - | - | - |
| Comparative example 27 | - | - | - | - | - | - | - | - |
| Comparative example 28 | - | - | - | - | - | - | - | - |

EP 2 495 284 B1

[Table 19]

| | P2 layer | | | | | | Laminated film | | |
| | A2 content (Parts by mass) | M2 content (Parts by mass) | B2 concentration $W_{B2}$ (% by mass) | C2 concentration $W_{C2}$ (% by mass) | Presence or absence of dispersion phases | Percentage of the number of C2 being present or the like in dispersion phases | Thickness ($10^3$nm) | Laminated ratio | $W_{C1}-W_{C2}$ |
|---|---|---|---|---|---|---|---|---|---|
| Comparative example 14 | - | - | - | - | - | - | - | - | - |
| Comparative example 15 | - | - | - | - | - | - | - | - | - |
| Comparative example 16 | - | - | - | - | - | - | - | - | - |
| Comparative example 17 | - | - | - | - | - | - | - | - | - |
| Comparative example 18 | - | - | - | - | - | - | - | - | - |
| Comparative example 19 | - | - | - | - | - | - | - | - | - |
| Comparative example 20 | - | - | - | - | - | - | - | - | - |
| Comparative example 21 | - | - | - | - | - | - | - | - | - |
| Comparative example 22 | - | - | - | - | - | - | - | - | - |
| Comparative example 23 | - | - | - | - | - | - | - | - | - |
| Comparative example 24 | - | - | - | - | - | - | - | - | - |
| Comparative example 25 | - | - | - | - | - | - | - | - | - |
| Comparative example 26 | - | - | - | - | - | - | - | - | - |

(continued)

| | P2 layer | | | | | | | Laminated film | |
| | A2 content (Parts by mass) | M2 content (Parts by mass) | B2 concentration $W_{B2}$ (% by mass) | C2 concentration $W_{C2}$ (% by mass) | Presence or absence of dispersion phases | Percentage of the number of C2 being present or the like in dispersion phases | Thickness ($10^3$nm) | Laminated ratio | $W_{C1}$-$W_{C2}$ |
|---|---|---|---|---|---|---|---|---|---|
| Comparative example 27 | - | - | - | - | - | - | - | - | - |
| Comparative example 28 | - | - | - | - | - | - | - | - | - |

[Table 20]

| | Δb | Tensile elongation at break of film | | Tensile elongation at break of back sheet | |
|---|---|---|---|---|---|
| | | Tensile elongation retention after moist-heat resistance test (%) | Tensile elongation retention after weathering test (%) | Tensile elongation retention after moist-heat resistance test (%) | Tensile elongation retention after weathering test (%) |
| Comparative example 14 | 5 | - | - | - | - |
| Comparative example 15 | 4 | 47.6 | 14 | 47.6 | 14 |
| Comparative example 16 | 4 | - | - | - | - |
| Comparative example 17 | 5 | 48.1 | 10 | 48.1 | 10 |
| Comparative example 18 | 5 | - | - | - | - |
| Comparative example 19 | 1 | 42.2 | 15 | 42.2 | 15 |
| Comparative example 20 | 1 | 42.5 | 14 | 42.5 | 14 |
| Comparative example 21 | 1 | 43.0 | 10 | 43.0 | 10 |
| Comparative example 22 | 15 | 65.0 | 8 | 65.0 | 8 |
| Comparative example 23 | 15 | 69.2 | 7 | 69.2 | 7 |
| Comparative example 24 | 15 | 74.0 | 6 | 74.0 | 6 |
| Comparative example 25 | 12 | 63.0 | 35 | 63.0 | 35 |
| Comparative example 26 | 12 | 67 | 32 | 67 | 32 |
| Comparative example 27 | 12 | 73 | 30 | 73 | 30 |
| Comparative example 28 | 8 | 45.2 | 15 | 45.2 | 15 |

(Description of Abbreviations)

PCHT: Polycyclohexylenedimethylene terephthalate
PCHT/I: 5 mol% isophthalic acid copolymerized polycyclohexylenedimethylene terephthalate
PCHT/G: 13 mol% ethylene glycol copolymerized polycyclohexylenedimethylene terephthalate
PET: Polyethylene terephthalate
PEN: Polyethylene-2,6-naphthalenedicarboxylate
PET/N: 3 mol% naphthalene dicarboxylic acid copolymerized polyethylene terephthalate
PPS: Polyphenylene sulfide
PEDPC: Polyethylene diphenylcarboxylate

Percentage of the cases where C1 (C2) is present or the like in dispersion phase: Percentage of the cases where C1 (C2) is present in a dispersion phase or where C1 (C2) is in contact with the dispersion phase

INDUSTRIAL APPLICABILITY

The biaxially oriented polyester film of the present invention is a polyester film that has an excellent balance of hydrolysis resistance and UV light resistance and is able to maintain mechanical strength even when exposed to a harsh atmosphere such as outdoor use over a long period of time, and, by exploiting these properties, it can be suitably used in applications such as electrical insulating materials such as solar battery back sheets, planar heating elements, or flat cables; capacitor materials; automotive materials; and building materials.

DESCRIPTION OF SYMBOLS

1:    Solar battery back sheet
2:    Transparent filler agent
3:    Electric generating element
4:    Transparent substrate
5:    Sunlight

**Claims**

1.   A biaxially oriented polyester film which is a polyester film having a polyester layer (P1 layer) containing a polyester (A1) comprising ethylene terephthalate as a main constituent, a high melting point resin (B1) having a melting point $Tm_{B1}$ of not less than 260°C and not more than 320°C, and inorganic particles (C1), wherein the content of the high melting point resin (B1) in the P1 layer, $W_{B1}$, is not less than 2% by mass and not more than 40% by mass based on the P1 layer; in the P1 layer, dispersion phases composed of the high melting point resin (B1) are present in the polyester (A1); and the average longitudinal length of the dispersion phases is not more than 10,000 nm (10 $\mu$m).

2.   The biaxially oriented polyester film according to claim 1, wherein, in said P1 layer, 70% or more of the total number of said inorganic particles (C1) are present in said dispersion phases or in contact with said dispersion phases.

3.   The biaxially oriented polyester film according to claim 1 or 2, wherein said high melting point resin (B1) is at least one resin selected from the group consisting of resins comprising 1,4-cyclohexanedimethylene terephthalate, ethylene-2,6-naphthalenedicarboxylate, and phenylene sulfide as a main component.

4.   The biaxially oriented polyester film according to any one of claims 1 to 3, which is a laminated polyester film having said polyester layer (P1 layer) and a polyester layer (P2 layer) containing a polyester (A2) comprising ethylene terephthalate as a main constituent, a high melting point resin (B2) having a melting point of not less than 260°C and not more than 320°C, and inorganic particles (C2), wherein, in the P2 layer, dispersion phases composed of the high melting point resin (B2) are present in the polyester (A2); the content of the inorganic particles (C2) in the P2 layer, $W_{C2}$, is not less than 0.1% by mass and not more than 5% by mass based on the P2 layer; and the difference between the content of the inorganic particles (C1) in the P1 layer, $W_{C1}$ (% by mass), and the content of the inorganic particles (C2) in the P2 layer, $W_{C2}$ (% by mass), $W_{C1} - W_{C2}$, is not less than 5% by mass and not more than 25% by mass.

5.   A solar battery back sheet using the biaxially oriented polyester film according to claims 1 to 4.

6.   The solar battery back sheet according to claim 5, wherein said biaxially oriented polyester film is provided at at least one outermost side.

7.   The solar battery back sheet according to claim 5 or 6, wherein at least one outermost layer is the P1 layer.

8.   A solar battery using the solar battery back sheet according to any one of claims 5 to 7.

9.   A method of producing the biaxially oriented polyester film according to claims 1 to 4, which is a method of producing the polyester film having the polyester layer (P1 layer) containing the polyester (A1) comprising ethylene terephthalate as a main component; at least one high melting point resin (B1) selected from the group consisting of resins comprising 1,4-cyclohexanedimethylene terephthalate, ethylene-2,6-naphthalenedicarboxylate, and phenylene sulfide as a main component; and the inorganic particles (C1), wherein the high melting point resin (B1) and the inorganic particles (C1) are melt kneaded to produce a masterpellet (M1); and the polyester (A1) and the masterpellet (M1) are melt kneaded under conditions satisfying any of the following equations (i) to (iv), extruded into sheet form, and then biaxially stretched;

wherein the melt viscosity of the polyester (A1) is $\eta_A$; the melt viscosity of the masterpellet (M1) is $\eta_{M1}$; $Tm_{B1}$ is the melting point (°C) of the high melting point resin (B1); Tc is the extrusion temperature (°C) during melt film forming; and $\eta_A$ and $\eta_{M1}$ are the melt viscosity of the polyester (A1) and the masterpellet (M1), respectively, at a temperature of Tc (°C) and a shear rate of 200 sec$^{-1}$;

$$\eta_A/\eta_{M1} \geq 0.2 \quad (i)$$

$$\eta_A/\eta_{M1} \leq 1.0 \quad (ii)$$

$$\eta_A/\eta_{M1} \geq -0.16 \times (Tc - Tm_{B1}) + 2.6 \quad (iii)$$

$$\eta_A/\eta_{M1} \leq -0.08 \times (Tc - Tm_{B1}) + 2.6 \quad (iv).$$

**Patentansprüche**

1. Biaxial orientierte Polyesterfolie, die eine Polyesterfolie ist, die eine Polyesterschicht (P1-Schicht) aufweist, die einen Polyester (A1), der als einen Hauptbestandteil Ethylenterephthalat umfasst, ein Harz mit hohem Schmelzpunkt (B1), das einen Schmelzpunkt $Tm_{B1}$ von nicht weniger als 260 °C und nicht mehr als 320 °C aufweist, und anorganische Partikel (C1) enthält, wobei der Gehalt des Harzes mit hohem Schmelzpunkt (B1) in der P1-Schicht, $W_{B1}$, nicht weniger als 2 Masse-% und nicht mehr als 40 Masse-% beträgt, basierend auf der P1-Schicht; wobei in der P1-Schicht in dem Polyester (A1) Dispersionsphasen vorliegen, die aus dem Harz mit hohem Schmelzpunkt (B1) bestehen; und die durchschnittliche Länge in Längsrichtung von den Dispersionsphasen nicht mehr als 10.000 nm (10 μm) beträgt.

2. Biaxial orientierte Polyesterfolie nach Anspruch 1, wobei in der P1-Schicht 70 % oder mehr von der Gesamtzahl der anorganischen Partikeln (C1) in den Dispersionsphasen vorliegen oder mit den Dispersionsphasen im Kontakt sind.

3. Biaxial orientierte Polyesterfolie nach Anspruch 1 oder 2, wobei das Harz mit hohem Schmelzpunkt (B1) mindestens ein Harz ist, das aus der Gruppe ausgewählt ist bestehend aus Harzen, die als einen Hauptbestandteil 1,4-Cyclohexandimethylenterephthalat, Ethylen-2,6-naphthalendicarboxylat und Phenylensulfid umfassen.

4. Biaxial orientierte Polyesterfolie nach einem der Ansprüche 1 bis 3, die eine laminierte Polyesterfolie ist, welche die Polyesterschicht (P1-Schicht) und eine Polyesterschicht (P2-Schicht) aufweist, die einen Polyester (A2), der als einen Hauptbestandteil Ethylenterephthalat, ein Harz mit einem hohen Schmelzpunkt (B2), das einen Schmelzpunkt von nicht weniger als 260 °C und nicht mehr als 320°C aufweist, und anorganische Partikel (C2) enthält, wobei in der P2-Schicht in dem Polyester (A2) Dispersionsphasen vorliegen, die aus dem Harz mit hohem Schmelzpunkt (B2) bestehen;
wobei der Gehalt der anorganischen Partikel (C2) in der P2-Schicht, $W_{c2}$, nicht weniger als 0,1 Masse-% und nicht mehr als 5 Masse-% beträgt, basierend auf der P2-Schicht; und die Differenz zwischen dem Gehalt der anorganischen Partikel (C1) in der P1-Schicht, $W_{C1}$ (Masse-%), und dem Gehalt der anorganischen Partikel (C2) in der P2-Schicht, $W_{C2}$ (Masse-%), $W_{C1} - W_{C2}$, nicht weniger als 5 Masse-% und nicht mehr als 25 Masse-% beträgt.

**5.** Solarbatterierückensheet, wobei die biaxial orientierte Polyesterfolie nach den Ansprüchen 1 bis 4 verwendet wird.

**6.** Solarbatterierückensheet nach Anspruch 5, wobei die biaxial orientierte Polyesterfolie auf mindestens einer äußersten Seite bereitgestellt ist.

**7.** Solarbatterierückensheet nach Anspruch 5 oder 6, wobei mindestens eine äußerste Schicht die P1-Schicht ist.

**8.** Solarbatterie, wobei das Solarbatterierückensheet nach einem der Ansprüche 5 bis 7 verwendet wird.

**9.** Verfahren zum Herstellen der biaxial orientierten Polyesterfolie nach den Ansprüchen 1 bis 4, das ein Verfahren zum Herstellen der Polyesterfolie ist, die die Polyesterschicht (P1-Schicht) aufweist, die den Polyester (A1) enthält, der als einen Hauptbestandteil Ethylenterephthalat umfasst; mindestens ein Harz mit hohem Schmelzpunkt (B1) enthält, das aus der Gruppe ausgewählt ist, bestehend aus Harzen, die als einen Hauptbestandteil 1,4-Cyclohexandimethylenterephthalat, Ethylen-2,6-naphthalendicarboxylat und Phenylensulfid umfassen; und die anorganische Partikel (C1) enthält, wobei das Harz mit hohem Schmelzpunkt (B1) und die anorganischen Partikel (C1) schmelzgeknetet werden, um ein Masterpellet (M1) herzustellen; und wobei der Polyester (A1) und das Masterpellet (M1) unter Bedingungen schmelzgeknetet werden, die irgendeine der folgenden Gleichungen (i) bis (iv) erfüllen, sie in Sheetform extrudiert werden und dann biaxial verschreckt werden;
wobei die Schmelzviskosität des Polyesters (A1) $n_A$ ist; die Schmelzviskosität des Masterpellets (M1) $\eta_{M1}$ ist; $Tm_{B1}$ der Schmelzpunkt (°C) des Harzes mit hohem Schmelzpunkt (B1) ist; Tc die Extrusionstemperatur (°C) während der Schmelzfolienbildung ist; und $\eta_A$ und $\eta_{M1}$ die Schmelzviskosität des Polyesters (A1) bzw. des Masterpellets (M1) bei einer Temperatur Tc (°C) und einer Schergeschwindigkeit von 200 $s^{-1}$ sind;

$$\eta_A/\eta_{M1} \geq 0{,}2 \qquad\qquad (i)$$

$$\eta_A/\eta_{M1} \leq 1{,}0 \qquad\qquad (ii)$$

$$\eta_A/\eta_{M1} \geq -0{,}16 \times (Tc - Tm_{B1}) + 2{,}6 \qquad (iii)$$

$$\eta_A/\eta_{M1} \leq -0{,}08 \times (Tc - Tm_{B1}) + 2{,}6 \qquad (iv).$$

**Revendications**

**1.** Film de polyester orienté biaxialement qui est un film de polyester ayant une couche de polyester (couche P1) contenant un polyester (A1) comprenant du téréphtalate d'éthylène en tant que constituant principal, une résine de point de fusion élevé (B1) ayant un point de fusion $Tm_{B1}$ qui n'est pas inférieur à 260 °C et n'est pas supérieur à 320 °C, et des particules inorganiques (C1), la teneur en résine de point de fusion élevé (B1) dans la couche P1, $W_{B1}$, n'étant pas inférieure à 2 % en poids et pas supérieure à 40 % en poids, par rapport à la couche P1 ; dans la couche P1, des phases de dispersion composées de la résine de point de fusion élevé (B1) sont présentes dans le polyester (A1) ; et la longueur longitudinale moyenne des phases de dispersion n'est pas supérieure à 10 000 nm (10 μm).

**2.** Film de polyester orienté biaxialement selon la revendication 1, dans lequel dans ladite couche P1, 70 % ou plus du nombre total desdites particules inorganiques (C1) sont présentes dans lesdites phases de dispersion ou en contact avec lesdites phases de dispersion.

**3.** Film de polyester orienté biaxialement selon la revendication 1 ou 2, dans lequel ladite résine de point de fusion élevé (B1) est au moins une résine choisie dans le groupe constitué par les résines comprenant le téréphtalate de 1,4-cyclohexanediméthylène, le dicarboxylate d'éthylène-2,6-naphtalène et le sulfure de phénylène en tant que composant principal.

**4.** Film de polyester orienté biaxialement selon l'une quelconque des revendications 1 à 3, qui est un film de polyester stratifié ayant ladite couche de polyester (couche P1) et une couche de polyester (couche P2) contenant un polyester (A2) comprenant du téréphtalate d'éthylène en tant que constituant principal, une résine de point de fusion élevé (B2) ayant un point de fusion qui n'est pas inférieur à 260 °C et n'est pas supérieur à 320 °C, et des particules inorganiques (C2), dans lequel, dans la couche P2, des phases de dispersion composées de la résine de point de fusion élevé (B2) sont présentes dans le polyester (A2) ; la teneur en particules inorganiques (C2) dans la couche P2, $W_{C2}$, n'est pas inférieure à 0,1% en masse et n'est pas supérieure à 5 % en masse par rapport à la couche P2 ; et la différence entre la teneur en particules inorganiques (C1) dans la couche P1, $W_{C1}$ (% en masse), et la teneur en particules inorganiques (C2) dans la couche P2, $W_{C2}$ (% en masse), $W_{C1} - W_{C2}$ n'est pas inférieure à 5 % en masse et n'est pas supérieure à 25 % en masse.

5. Feuille arrière d'une batterie solaire utilisant le film de polyester orienté biaxialement selon l'une quelconque des revendications 1 à 4.

6. Feuille arrière d'une batterie solaire selon la revendication 5, dans laquelle ledit film de polyester orienté biaxialement est utilisé sur au moins un côté le plus à l'extérieur.

7. Feuille arrière d'une batterie solaire selon la revendication 5 ou 6, dans laquelle au moins une couche la plus à l'extérieur est la couche P1.

8. Batterie solaire utilisant la feuille arrière d'une batterie solaire selon l'une quelconque des revendications 5 à 7.

9. Procédé de production du film de polyester orienté biaxialement selon l'une quelconque des revendications 1 à 4, qui est un procédé de production du film de polyester ayant la couche de polyester (couche P1) contenant le polyester (A1) comprenant du téréphtalate d'éthylène en tant que composant principal ; au moins une résine de point de fusion élevée (B1) choisie dans le groupe constitué par les résines comprenant le téréphtalate de 1,4-cyclohexanediméthylène, le dicarboxylate d'éthylène-2,6-naphtalène et le sulfure de phénylène en tant que composant principal ; et les particules inorganiques (C1), la résine de point de fusion élevé (B1) et les particules inorganiques (C1) étant mélangées à l'état fondu pour produire une pastille maître (M1) ; et le polyester (A1) et la pastille maître (M1) sont mélangés à l'état fondu dans des conditions satisfaisant à l'une quelconque des équations (i) à (iv) suivantes, extrudés sous la forme d'une feuille, et ensuite étirés biaxialement ;
dans lequel la viscosité du polyester (A1) est $\eta_A$ ; la viscosité à l'état fondu de la pastille maître (M1) est $\eta_{M1}$ ; $Tm_{B1}$ est le point de fusion (°C) de la résine de point de fusion élevé (B1) ; $T_C$ est la température d'extrusion (°C) pendant la formation du film fondu ; et $\eta_A$ et $\eta_{M1}$ sont la viscosité à l'état fondu du polyester (A1) et de la pastille maître (M1) respectivement, à une température Tc (°C) et une vitesse de cisaillement de 200 sec$^{-1}$ ;

$$\eta_A/\eta_{M1} \geq 0{,}2 \quad (i)$$

$$\eta_A/\eta_{M1} \leq 1{,}0 \quad (ii)$$

$$\eta_A/\eta_{M1} \geq -0{,}16 \times (Tc - Tm_{B1}) + 2{,}6 \quad (iii)$$

$$\eta_A/\eta_{M1} \leq -0{,}08 \times (Tc - Tm_{B1}) + 2{,}6 \quad (iv).$$

[Figure 1]

**EP 2 495 284 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20050118406 A
- JP 60031526 A
- JP 9227767 A
- JP 2007302878 A
- JP 11506487 W
- JP 2007070430 A
- JP 2004223714 A
- JP 2004098442 A
- JP 2191638 A
- JP 8244188 A